# EUROPEAN PATENT APPLICATION

(11) **EP 4 583 673 A1**
(43) Date of publication of application: **09.07.2025**
(21) Application number: 24222087.9
(22) Date of filing: 20.12.2024
(51) Int. Cl.: H10K 50/16, H10K 50/17, H10K 50/18

(54) **LIGHT EMITTING DEVICE AND DISPLAY DEVICE INCLUDING THE SAME**

(30) Priority: 21.12.2023 KR 20230188857
(71) Applicant: Samsung Electronics Co., Ltd., Suwon-si, Gyeonggi-do 16677 (KR)
(72) Inventor: SEO, Hong Kyu, 16678 Suwon-si (KR); CHA, SOONMIN, 16678 Suwon-si (KR); KWON, Ha Il, 16678 Suwon-si (KR); KIM, Enjung, 16678 Suwon-si (KR); KIM, Sung Woo, 16678 Suwon-si (KR); CHUNG, You Jung, 16678 Suwon-si (KR)
(74) Representative: Elkington and Fife LLP

(57) **Abstract**

A method of producing a light emitting device includes: forming a light emitting layer including a semiconductor nanoparticle on a first electrode; forming an electron transport layer including a metal oxide nanoparticle on the light emitting layer; forming a thin film conductor on the electron transport layer; placing the electron transport layer, the thin film conductor, and an acid material together in a space defined by a container; and keeping the defined space at a post-treatment temperature of greater than or equal to about 40°C and less than or equal to about 200°C. The light emitting layer is configured to emit a first light when a voltage is applied, a thickness of the thin film conductor is greater than or equal to about 1 nm and less than 100 nm, and the acid material includes a polymeric acid, a non-polymeric carboxylic acid compound, or a combination thereof.

## Description

### FIELD OF THE INVENTION

The present disclosure relates to a light emitting (e.g., electroluminescent) device and a display device including the electroluminescent) device.

### BACKGROUND OF THE INVENTION

A semiconductor nanoparticle (e.g., a semiconductor nanocrystal particle) having a nanometer size may exhibit luminescence properties. For example, a quantum dot including a semiconductor nanocrystal may exhibit a quantum confinement effect. The light emission from the semiconductor nanoparticle may occur when an electron in an excited state resulting from light excitation or an applied voltage transitions from a conduction band to a valence band. The semiconductor nanoparticle may be configured to emit light of a desired wavelength region by adjusting a size of the semiconductor nanoparticle, a composition of the semiconductor nanoparticle, or a combination thereof.

A semiconductor nanoparticle may be used, for example, in a light emitting device (e.g., an electroluminescent device) or a display device including the electroluminescent device.

### SUMMARY OF THE INVENTION

An embodiment provides a method of producing a light emitting device that emits light, for example, by applying a voltage to a nanostructure (e.g., a semiconductor nanoparticle such as a quantum dot), for example with or without a separate irradiation light source.

An embodiment provides the light emitting device.

An embodiment provides a display device (e.g., a quantum dot-light emitting diode (QD-LED) display device) that includes a plurality of semiconductor nanoparticles such as a quantum dots as a component of a light emitting layer in a pixel configuration (e.g., in a configuration of a blue pixel, a red pixel, a green pixel, or a combination thereof).

In an embodiment, a method of producing a light emitting device includes: forming a light emitting layer including a semiconductor nanoparticle on a first electrode; forming an electron transport layer including a metal oxide nanoparticle on the light emitting layer; forming a thin film conductor (or a second electrode) on the electron transport layer to obtain a stacked structure; and conducting a post-treatment of the stacked structure with an acid material and a container, where the light emitting layer is configured to emit a first light when a voltage is applied, and a thickness of the thin film conductor is greater than or equal to about 1 nanometer (nm) and less than 100 nm. The post-treatment includes placing at least a portion of the stacked structure (e.g., the electron transport layer and the thin film conductor), and the acid material together in a space defined by the container; and keeping the defined space at a post-treatment temperature of greater than or equal to about 40 degrees in Celsius (°C) and less than or equal to about 200°C. The acid material includes a polymeric acid compound, a non-polymeric carboxylic acid compound, or a combination thereof.

In the stacked structure, the first electrode, the light emitting layer, the electron transport layer, and the thin film conductor may be sequentially stacked.

The space may be a closed space.

The light emitting device may further include a hole auxiliary layer between the light emitting layer and the first electrode. The hole auxiliary layer may include a hole transport layer (e.g., including an organic compound), a hole injection layer, or a combination thereof.

The semiconductor nanoparticle may include a first semiconductor nanocrystal including zinc, selenium, and tellurium, and a second semiconductor nanocrystal including a zinc chalcogenide, the second semiconductor nanocrystal being different from the first semiconductor nanocrystal. The semiconductor nanoparticle may include a first semiconductor nanocrystal including (a Group III-V compound or an indium phosphide compound including) indium, phosphorus, and optionally zinc; and a second semiconductor nanocrystal including a zinc chalcogenide and different from the first semiconductor nanocrystal.

A size or an average size (hereinafter, "size") of the semiconductor nanoparticle may be greater than or equal to about 4 nanometers (nm), greater than or equal to about 5 nm, greater than or equal to about 7 nm, greater than or equal to about 8 nm, greater than or equal to about 9 nm, or greater than or equal to about 10 nm. The size of the semiconductor nanoparticle may be less than or equal to about 30 nm, less than or equal to about 20 nm, less than or equal to about 15 nm, less than or equal to about 12 nm, or less than or equal to about 10 nm.

The semiconductor nanoparticle may have a core-shell structure that includes a core including the first semiconductor nanocrystal and a shell disposed on the core and including the second semiconductor nanocrystal.

The electron transport layer may be adjacent to (or disposed directly on) the light emitting layer.

A size or an average size (hereinafter, referred to as "size") of the metal oxide nanoparticle(s) may be greater than or equal to about 1 nm, or greater than or equal to about 3 nm. The size of the metal oxide nanoparticle(s) may be less than or equal to about 10 nm, or less than or equal to about 8 nm.

The metal oxide nanoparticle may include a zinc oxide. The metal oxide nanoparticle may include zinc; and optionally a Group IIA metal, Zr, W, Li, Ti, Y, Al, Ga, In, Sn, Co V, or a combination thereof. The metal oxide nanoparticle may further include an alkali metal. In an embodiment, the metal oxide may include zinc, a Group IIA metal, and optionally an alkali metal.

The metal oxide nanoparticle may include a compound represented by Zn₁₋ₓ MₓO, wherein, M is Mg, Ga, Ca, Zr, Co, W, Li, Ti, Y, Al, or a combination thereof, and 0 ≤ x ≤ 0.5. The x may be greater than or equal to about 0.01, greater than or equal to about 0.03, greater than or equal to about 0.05, greater than or equal to about 0.1, or greater than or equal to about 0.15. The x may be less than or equal to about 0.45, or less than or equal to about 0.4.

The thin film conductor may have a thickness of greater than about 10 nm, or greater than or equal to 11 nm. The thin film conductor may have a thickness of less than or equal to about 80 nm, less than or equal to about 60 nm, less than or equal to about 50 nm, or less than or equal to about 40 nm.

The thin film conductor may be configured to exhibit a light transmittance of greater than or equal to about 25%, greater than or equal to about 35%, greater than or equal to about or 40% for the first light. The light transmittance may be less than or equal to about 90%, less than or equal to about 70%, or less than or equal to about 55%.

The first electrode may be configured to reflect at least a portion of the first light.

The thin film conductor may include silver, aluminum, magnesium, tungsten, nickel, cobalt, platinum, palladium, calcium, LiF, gold, copper, or a combination thereof (e.g., alloy). The thin film conductor may include silver and magnesium.

The acid material may have a solubility of greater than or equal to about 1 gram per liter (g/L), with respect to water or alcohol, for example at a temperature of about 20 °C. The solubility of the acid material may be less than or equal to about 5000 g/L, less than or equal to about 4000 g/L, less than or equal to about 3000 g/L, or less than or equal to about 1000 g/L.

The acid material (for example, the polymeric acid compound) may include a carboxylic acid group (e.g., COOH), a phosphonic acid group (PO(OH)₂), a sulfonic acid group (SOsH), or a combination thereof, for example, in a repeating unit.

The acid material (e.g., the non-polymeric carboxylic acid compound or the polymeric acid compound) may have a molecular weight or an average molecular weight (hereinafter, "molecular weight) that is greater than or equal to about 50 grams per mole (g/mol), greater than or equal to about 100 g/mol, greater than or equal to about 200 g/mol, greater than or equal to about 800 g/mol, or greater than or equal to about 20,000 g/mol, and less than or equal to about less than or equal to about 8,000,000 g/mol, less than or equal to about 1,000,000 g/mol, less than or equal to about 550,000 g/mol, or less than or equal to about 400 g/mol. The molecular weight of the acid material (e.g., the non-polymeric carboxylic acid compound or the polymeric acid compound) may be greater than or equal to about 1200 g/mol, e.g., greater than or equal to about 1700 g/mol. The molecular weight of the acid material may be less than or equal to about 1,200,000 g/mol, e.g., less than or equal to about 500,000 g/mol.

In an embodiment, the non-polymeric carboxylic acid compound may have a molecular weight within the aforementioned range or the range described herein, for example, of greater than or equal to about 100 grams per mole (g/mol) and less than or equal to about 500 g/mol.

In an embodiment, the polymeric acid compound may have a molecular weight (e.g., an average molecular weight) within the aforementioned range or the range described herein, for example, of greater than or equal to about 20,000 g/mol and less than or equal to about 550,000 g/mol

The acid material may be provided in a form of a film or a layer (i.e., may be a film or a layer of the acid material) or in a form of a solution (for example, prepared by dissolving the acid material in a solvent such as water or an organic solvent). In an embodiment, the acid material may be a film or a layer (hereinafter, can be referred to as "film") of the polymeric acid compound. The acid material may be spaced apart from the electron transport layer and the thin film conductor. The acid material (or film) may be disposed to face the thin film conductor (e.g., the main surface of the thin film). The acid material (film) may be disposed to face the electron transport layer.

The acid material film may have a thickness of greater than or equal to about 1 nm, greater than or equal to about 10 nm, greater than or equal to about 100 nm, greater than or equal to about 1 micrometer (µm), greater than or equal to about 2 µm, greater than or equal to about 5 µm, greater than or equal to about 10 µm, greater than or equal to about 100 µm, or greater than or equal to about 1000 µm. The acid material film may have a thickness of less than or equal to about 1 centimeter, less than or equal to about 50 millimeters, less than or equal to about 1.5 millimeters, less than or equal to about 900 µm, less than or equal to about 100 µm, less than or equal to about 50 µm, or less than or equal to about or 10 µm.

The acid material (or a film thereof) or the polymeric acid compound may exhibit a solubility of greater than or equal to about 1 gram per liter (g/L), or greater than or equal to about 200 g/L, with respect to water for example, at room temperature for example, at a temperature of about 20 °C to about 23 °C. The acid material (or a film thereof) or the polymeric acid compound may exhibit a solubility of greater than or equal to about 1 g/L, or greater than or equal to about 200 g/L with respect to a C1 to C5 alcohol, at room temperature for example, at a temperature of about 20 °C to about 23 °C.

The acid material (or a film thereof) or the polymeric acid compound may exhibit a solubility of less than or equal to about 5000 g/L, less than or equal to about 4000 g/L, less than or equal to about 3000 g/L, less than or equal to about 1000 g/L or less than or equal to about 600 g/L, with respect to water or with respect to a C1 to C5 alcohol.

The acid material (or a film thereof) or the polymeric acid compound may exhibit a pH of greater than or equal to about 0.5, or greater than or equal to about 1 and less than or equal to about 5, or less than or equal to about 4.5, in a solution state (e.g., in an aqueous solution).

The acid material or the polymeric acid compound may include a polyacrylic acid compound, a polymethacrylic acid, a polyacrylic acid-methacrylic acid, an alkali metal salt (e.g., a sodium salt) of poly(meth)acrylic acid, a copolymer including a (meth)acrylic acid repeating unit, a polyvinyl phosphonic acid, a poly(aromatic sulfonic acid) such as a poly(4-styrenesulfonic acid), a poly(4-styrene sulfonic acid-co-maleic acid), an alkali metal salt (e.g., a partial salt) of a poly(aromatic sulfonic acid), a poly(vinyl sulfonic acid), an alkali metal salt (e.g., a partial salt) of poly(vinyl sulfonic acid), a polymaleic acid, or a combination thereof (for example, a copolymer of at least two of the foregoing polymers or a mixture of at least two of the foregoing polymers). The alkali metal salt may be a partial alkali metal salt.

The acid material (or a film thereof) may further include or may not include an additive (e.g., an inorganic acid such as a sulfuric acid, a sulfinic acid compound (e.g., represented by R(SO₂H)ₙ), a sulfonic acid compound (e.g., represented by R(SO₃H)ₙ), or a combination thereof. In the formulae, the R is a substituted or unsubstituted C1 to C50, C3-C25, or C5-C8 aliphatic or aromatic hydrocarbon group, and the n is 1 to 10, 2 to 8, 3 to 6, or 4 to 5.

The acid material or the non-polymeric carboxylic acid compound may include (or may be) a C2-50 carboxylic acid compound represented by R(COOH)n, wherein R is a substituted or unsubstituted, C1 to C50 or C3-C25 or C5-C8 aliphatic or aromatic hydrocarbon group, and n is 1 to 10, 2 to 8, 3 to 6, or 4 to 5.

The acid material or the non-polymeric carboxylic acid compound may include (or may be) a compound (e.g., a polycarboxylic acid compound) having 2 to 10 carboxylic acid groups.

The non-polymeric (poly)carboxylic acid compound may have 1 to 10, 2 to 5, 3 to 4, substituted or unsubstituted C₁₋₅₀, C₂₋₅₀, C₆₋₁₅, or C₈₋₁₀ aliphatic hydrocarbon group(s), 1 to 10, 2 to 5, 3 to 4 substituted or unsubstituted C₆₋₁₅ aromatic hydrocarbon group(s), or a combination thereof.

The non-polymeric (poly) carboxylic acid compound may further include a hydroxyl group.

The acid material or the non-polymeric carboxylic acid compound may include benzoic acid, succinic acid, maleic acid, fumaric acid, malic acid, glutaric acid, adipic acid, pimelic acid, citric acid, oxalic acid, malonic acid, phthalic acid, isophthalic acid, terephthalic acid, trimellitic acid, hemimellitic acid, azelaic acid, suberic acid, tartaric acid, itaconic acid, dodecanedioic acid, sulfuric acid, acetic acid, a (meth)acrylic acid, or a combination thereof.

The acid material may include the polymeric acid compound and the non-polymeric carboxylic acid compound.

An amount of a crosslink type polymer in the acid material may be less than about 1 weight percent (wt%), or less than or equal to about 0.9 wt%, based on a total weight of the acid material.

The acid material may not include a crosslink type (e.g., crosslinked) polymer.

At least a portion of the acid material may be configured to dissolve upon being immersed in water or a C1 to C5 alcohol. The acid material may be configured to dissolve at least partially upon being immersed in water or a C1 to C5 alcohol. The temperature of the water or the temperature of the C1 to C5 alcohol may be greater than or equal to about 20 °C or greater than or equal to about 25 °C. The temperature of the water or the temperature of the C1 to C5 alcohol may be less than or equal to a boiling point thereof (for example, less than or equal to about 50°C, or less than or equal to about 30°C).

The container may include a light transmitting member (e.g., light transmitting material or light transmitting component). The container may include an additional member (e.g., a sealing member). The container may be an encapsulation element (e.g., an encapsulation glass) for the stacked structure. The container or the light-transmitting member may include an organic material such as a polymer, an inorganic material such as glass, an organic-inorganic hybrid material, or a combination thereof. The container may be an oven or a chamber.

The container may be an oven including a hollow chamber and an element configured to heat the chamber in a controlled way, and the acid material may be provided in a solution form

The acid material (for example, the polymeric acid compound) may be disposed adjacent to or in contact with a surface of the container or the light-transmitting member. The acid material may be applied or coated on a surface of the container or the light-transmitting member.

The method may further include preparing a composition including a liquid vehicle (e.g., a solvent); and the acid material. The composition may further include the additive.

The method may further include applying the composition to a surface of the container to form a film of the acid material. The method may further include placing the composition in a separate container and disposing the separate container in the space (e.g., an oven or a chamber).

The composition may be obtained by dissolving the acid material and optionally the additive in the liquid vehicle.

The liquid vehicle or the solvent may include water, a C1-10 alcohol, a nitrile solvent, an ester solvent, or a combination thereof.

The liquid vehicle or the solvent may contain water, ethanol, methanol, propanol, acetonitrile, ethyl acetate, or a combination thereof.

The defined space may be a closed space, for example, a sealed space or a hermetic or airtight space. A temperature of the post-treatment may be greater than or equal to about 45 °C, greater than or equal to about 50 °C, greater than or equal to about 70 °C, or greater than or equal to about 90 °C and less than or equal to about 180 °C, or less than or equal to about 120 °C. The post-treatment may be performed for a predetermined time. The predetermined time may be greater than or equal to about 10 minutes, greater than or equal to about 5 hours and less than or equal to about 10 days, or less than or equal to about 10 hours.

The method may further include separating the stacked structure from the container (for example, moving the stacked structure from the defined space) after the post-treatment.

The method may further include providing a conductive layer on the thin film conductor after the post-treatment to form a thin film conductor (or a second electrode) with an increased thickness.

In an embodiment, a light emitting device includes:
a first electrode (for example, a hole injecting conductor or an anode) and a second electrode, a light emitting layer disposed between the first electrode and the second electrode, and an electron transport layer disposed between the light emitting layer and the second electrode;
wherein the light emitting layer includes a semiconductor nanoparticle, and the light emitting layer is configured to emit a first light,
wherein the electron transport layer includes a metal oxide nanoparticle, and the metal oxide nanoparticle has a size of greater than or equal to about 1 nm and less than or equal to about 30 nm, and the metal oxide nanoparticle includes zinc; and optionally a Group IIA metal, Zr, W, Li, Ti, Y, Al, gallium, indium, tin (Sn), cobalt (Co), vanadium (V), or a combination thereof,
the second electrode has a thickness of greater than or equal to about 11 nm and less than or equal to about 50 nm, and
the second electrode exhibits a light transmittance for the first light that is greater than or equal to about 50% and less than or equal to about 100%, and
the first electrode is configured to reflect at least a portion of the first light.

The first electrode may include a hole injection conductor.

The second electrode may include an electron injection conductor.

The semiconductor nanoparticle or the light emitting layer may not contain cadmium, lead, mercury, or a combination thereof.

The second electrode may have a thickness of greater than or equal to about 12 nm.

The second electrode may have a thickness of less than or equal to about 40 nm.

The light emitting device may be configured to emit green light with application of a voltage. The electroluminescent device may be configured to emit blue light with application of a voltage. The electroluminescent device may be configured to emit red light with application of a voltage.

The light emitting device may further include a layer of an acid material (or an acid material film, hereinafter, "acid material film") disposed on the electron transport layer. Details of the acid material are the same as described herein. The acid material may include a polymeric acid compound.

The acid material film may be disposed to be spaced apart from the electron transport layer and the second electrode. The acid material film may be disposed to face the electron transport layer and the second electrode or the thin film conductor.

The acid material film may be disposed to be spaced apart from the electron transport layer and the second electrode. The acid material film may be disposed to face the electron transport layer and the second electrode or the thin film conductor.

The electron transport layer may have a first surface facing the light emitting layer and a second surface opposite to the first surface, and the acid material film may be disposed on or over the second surface.

The acid material film may be spaced apart from the electron transport layer (e.g., away from the electron transport layer).

A thickness of the acid material film may be greater than or equal to about 10 nm, or greater than or equal to about 100 nm. A thickness of the layer of the acid material may be less than or equal to about 100 micrometers (µm), or less than or equal to about 10 µm.

The thin film conductor or the second electrode may have a first surface facing a surface of the electron transport layer and a second surface opposite the first surface. The acid material film may be disposed with being spaced apart from the electron transport layer and the second electrode and facing at least a portion (e.g., all) of a surface of the electron transport layer and/or at least a portion (e.g., all) of a second surface of the second electrode.

Details of the semiconductor nanoparticle, the metal oxide nanoparticle, the first electrode, and the acid material and the film thereof are the same as described herein. Details of the second electrode are the same as described for the thin film conductor.

The light emitting device (for example, emitting blue light) may have a maximum luminous efficiency of greater than or equal to about 5 candela per ampere (cd/A), greater than or equal to about 5.5 cd/A, 6 cd/A, greater than or equal to about 6.5 cd/A, or greater than or equal to about 12 cd/A.

The light emitting device may be configured to emit blue light and may have a T90 of greater than or equal to about 20 hours, for example, as operated at an initial luminance of about 650 nits.

The light emitting device may exhibit a maximum luminance of greater than or equal to about 60,000 nits (candelas per square meter, cd/m²), greater than or equal to about 70,000 nits, or greater than or equal to about 80,000 nits.

The light emitting device may exhibit a maximum external quantum efficiency of greater than or equal to about 6%, greater than or equal to about 8%, or greater than or equal to about 10%.

In an embodiment, a display device may include the light emitting device (e.g., an electroluminescent device).

In an embodiment, an electronic device may include the light emitting device.

The display device or the electronic device may include (or may be) AR/VR device, a handheld terminal, a monitor, a notebook computer, a television, an electronic display board, a camera, an electronic display component for an automatic vehicle or an electric car.

According to an embodiment, a light emitting device exhibiting improved light emitting properties and lifespan characteristics is provided. The method of an embodiment can facilitate, for example, a mass production process of a front-emission type light emitting device.

### BRIEF DESCRIPTION OF THE DRAWINGS

The above and other advantages and features of this disclosure will become more apparent by describing in further detail exemplary embodiments thereof with reference to the accompanying drawings, in which:
FIG. 1A is a schematic cross-sectional view of a light emitting device according to an embodiment;
FIG. 1B is a schematic cross-sectional view of a light emitting device according to an embodiment;
FIG. 1C is a schematic cross-sectional view of a light emitting device according to an embodiment;
FIG. 2 is a schematic cross-sectional view of a light emitting device according to an embodiment;
FIG. 3 is a schematic cross-sectional view of a light emitting device according to an embodiment;
FIG. 4 is a schematic cross-sectional view of a light emitting device according to an embodiment;
FIG. 5 is a plan view of the light emitting device of FIG. 4.
FIG. 6 is a schematic cross-sectional view of a light emitting device according to an embodiment.
FIG. 7 illustrates a schematic cross-sectional view of a stacked structure for a post-treatment in a process according to an embodiment.
FIG. 8 shows a schematic cross-sectional view of the stacked structure obtained by the process wherein the stacked structure is removed from the container after the post-treatment in the process of manufacturing the light emitting device according to FIG. 7 and then a second electrode is formed and a new container (having no layer of the acid material) is provided.
FIG. 9 is a diagram schematically illustrating an example of post-treatment (using an oven or a chamber as a container) during a manufacturing process of a light emitting device according to an embodiment.
FIG. 10 is a schematic cross-sectional view of a light emitting device (RGB pixel) according to an embodiment.
FIG. 11 is a schematic plan view of a display panel according to an embodiment.
FIG. 12 is a schematic cross-sectional view showing a display panel of FIG. 11 taken along line IV-IV.

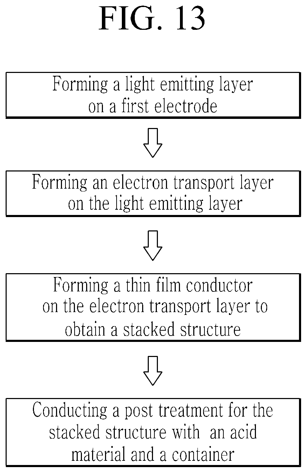

Fig. 13 is a flowchart of a method of producing a light emitting device according to an embodiment.

### DETAILED DESCRIPTION OF THE EMBODIMENTS

Advantages and characteristics of this disclosure, and a method for achieving the same, will become evident referring to the following example embodiments together with the drawings attached hereto. However, the embodiments should not be construed as being limited to the embodiments set forth herein. Rather, these embodiments are provided so that this disclosure will be thorough and complete, and will fully convey the scope of the invention to those skilled in the art.

In order to clearly explain the present disclosure, parts irrelevant to the description are omitted, and the same reference numerals are assigned to the same or similar elements throughout the specification. In the drawings, the thickness of layers, films, panels, regions, etc., are exaggerated for clarity. And in the drawings, for convenience of description, the thickness of some layers and regions are exaggerated. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

In addition, it will be understood that when an element such as a layer, film, region, or substrate is referred to as being "on" another element, it can be directly on the other element or intervening elements may also be present. In contrast, when an element is referred to as being "directly on" another element, there are no intervening elements present. Also, to be disposed "on" the reference portion means to be disposed above or below the reference portion and does not necessarily mean "above".

It will be understood that, although the terms "first," "second," "third," etc., may be used herein to describe various elements, components, regions, layers and/or sections, these elements, components, regions, layers and/or sections should not be limited by these terms. These terms are only used to distinguish one element, component, region, layer or section from another element, component, region, layer, or section. Thus, "a first element," "component," "region," "layer," or "section" discussed below could be termed a second element, component, region, layer, or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "At least one" is not to be construed as being limited to "a" or "an." "Or" means "and/or."

As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

As used herein, the term "cross-sectional view" is a view obtained by cutting a given 3-dimensional object, for example, in a substantially vertical direction and seeing the cut face laterally. As used herein, the term "plan view" is an orthographic projection of a given 3-dimensional object from the position of a horizontal plane through the object.

Unless otherwise defined, all terms (including technical and scientific terms) used herein have the same meaning as commonly understood by one of ordinary skill in the art to which this disclosure belongs. It will be further understood that terms, such as those defined in commonly used, e.g., non-technical, dictionaries, should be interpreted as having a meaning that is consistent with their meaning in the context of the relevant art and the present disclosure, and will not be interpreted in an idealized or overly formal sense unless expressly so defined herein.

Hereinafter, values of a work function, a conduction band, or a lowest unoccupied molecular orbital ("LUMO") (or valence band or highest occupied molecular orbital ("HOMO")) energy level is expressed as an absolute value from a vacuum level. In addition, when the work function or the energy level is referred to be "deep," "high" or "large," the work function or the energy level has a large absolute value based on "0 electron volts (eV)" of the vacuum level, while when the work function or the energy level is referred to be "shallow," "low," or "small," the work function or energy level has a small absolute value based on "0 eV" of the vacuum level.

As used herein, the average (value) may be mean or median. In an embodiment, the average (value) may be a mean average.

As used herein, the term "peak emission wavelength" is the wavelength at which a given emission spectrum of the light reaches its maximum.

As used herein, the term "Group" may refer to a group of Periodic Table.

As used herein, "Group I" refers to Group IA and Group IB, and examples may include Li, Na, K, Rb, and Cs, but are not limited thereto.

As used herein, "Group II" refers to Group IIA and Group IIB, and examples of Group II metal may be Cd, Zn, Hg, and Mg, but are not limited thereto.

As used herein, "Group III" refers to Group IIIA and Group IIIB, and examples of Group IIIA metal may be Al, In, Ga, and TI, and examples of Group IIIB may be scandium, yttrium, or the like, but are not limited thereto.

As used herein, "Group IV" refers to Group IVA and Group IVB, and examples of a Group IVA metal may be Si, Ge, and Sn, and examples of Group IVB metal may be titanium, zirconium, hafnium, or the like, but are not limited thereto.

As used herein, "Group V" includes Group VA and includes nitrogen, phosphorus, arsenic, antimony, and bismuth, but is not limited thereto.

As used herein, "Group VI" includes Group VIA and includes sulfur, selenium, and tellurium, but is not limited thereto.

As used herein, "metal" includes a semi-metal such as Si.

As used herein, a number of carbon atoms in a group or a molecule may be referred to as a subscript (e.g., C₆₋₅₀) or as C6 to C50.

As used herein, when a definition is not otherwise provided, "substituted" refers to replacement of at least one hydrogen of a compound or a group for a corresponding group moiety including a C1 to C30 alkyl group, a C2 to C30 alkenyl group, a C2 to C30 alkynyl group, a C6 to C30 aryl group, a C7 to C30 alkylaryl group, a C1 to C30 alkoxy group, a C1 to C30 heteroalkyl group, a C3 to C30 heteroalkylaryl group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group (-NO₂), a cyano group (-CN), an amino group (-NRR' wherein R and R' are each independently hydrogen or a C1 to C6 alkyl group), an azido group (-N₃), an amidino group (-C(=NH)NH₂), a hydrazino group (-NHNH₂), a hydrazono group (=N(NH₂)), an aldehyde group (-C(=O)H), a carbamoyl group (-C(O)NH₂), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation), a sulfonic acid group (-SOsH) or a salt thereof (-SOsM, wherein M is an organic or inorganic cation), a phosphoric acid group (-PO₃H₂) or a salt thereof (-POsMH or -PO₃M₂, wherein M is an organic or inorganic cation), or a combination thereof.

As used herein, when a definition is not otherwise provided, "hydrocarbon" or "hydrocarbon group" refers to a compound or a group including carbon and hydrogen (e.g., alkyl, alkenyl, alkynyl, or aryl group). The hydrocarbon group may be a monovalent group or a group having a valence of greater than one formed by removal of a, e.g., one or more, hydrogen atoms from alkane, alkene, alkyne, or arene. In the hydrocarbon or hydrocarbon group, a, e.g., at least one, methylene may be replaced by an oxide moiety, a carbonyl moiety, an ester moiety, -NH-, or a combination thereof. Unless otherwise stated to the contrary, the hydrocarbon compound or hydrocarbon group (alkyl, alkenyl, alkynyl, or aryl) may have 1 to 60, 2 to 32, 3 to 24, or 4 to 12 carbon atoms.

As used herein, when a definition is not otherwise provided, "alkyl" refers to a linear or branched saturated monovalent hydrocarbon group (methyl, ethyl hexyl, etc.). In an embodiment, an alkyl group may have from 1 to 50 carbon atoms, or 1 to 18 carbon atoms, or 1 to 12 carbon atoms.

As used herein, when a definition is not otherwise provided, "alkenyl" refers to a linear or branched monovalent hydrocarbon group having a carbon-carbon double bond. In an embodiment, an alkenyl group may have from 2 to 50 carbon atoms, or 2 to 18 carbon atoms, or 2 to 12 carbon atoms.

As used herein, when a definition is not otherwise provided, "alkynyl" refers to a linear or branched monovalent hydrocarbon group having a carbon-carbon triple bond. In an embodiment, an alkynyl group may have from 2 to 50 carbon atoms, or 2 to 18 carbon atoms, or 2 to 12 carbon atoms.

As used herein, when a definition is not otherwise provided, "aryl" refers to a group formed by removal of a, e.g., at least one, hydrogen from an arene (e.g., a phenyl or naphthyl group). In an embodiment, an aryl group may have 6 to 50 carbon atoms, or 6 to 18 carbon atoms, or 6 to 12 carbon atoms.

As used herein, when a definition is not otherwise provided, "hetero" refers to inclusion of 1 to 3 heteroatoms, e.g., N, O, S, Si, P, or a combination thereof.

As used herein, when a definition is not otherwise provided, "alkoxy" refers to an alkyl group linked to oxygen (e.g., alkyl-O-) for example, a methoxy group, an ethoxy group, or a sec-butyloxy group.

As used herein, when a definition is not otherwise provided, "amine" is a compound represented by NR₃, wherein each R is independently hydrogen, a C1-C12 alkyl group, a C7-C20 alkylaryl group, a C7-C20 arylalkyl group, or a C6-C18 aryl group.

As used herein, "poly(meth)acrylate" refers to a polyacrylate, a polymethacrylate, or a combination thereof.

In an embodiment, "an alkali metal salt" (for example, of a polymeric acid such as poly(meth)acrylic acid or polystryrene sulfonic acid) may include a partial alkali metal salt, a full alkali metal salt, or a combination thereof.

As used herein, the expression "not including cadmium (or other harmful heavy metal)" may refer to the case in which a concentration of cadmium (or another heavy metal deemed harmful) may be less than or equal to about 100 parts per million by weight (ppmw), less than or equal to about 50 ppmw, less than or equal to about 10 ppmw, less than or equal to about 1 ppmw, less than or equal to about 0.1 ppmw, less than or equal to about 0.01 ppmw, or about zero. In an embodiment, substantially no amount of cadmium (or other toxic heavy toxic metal) may be present or, if present, an amount of cadmium (or other heavy metal) may be less than or equal to a detection limit or as an impurity level of a given analysis tool (e.g., an inductively coupled plasma atomic emission spectroscopy instrument).

Unless mentioned to the contrary, a numerical range recited herein is inclusive. Unless mentioned to the contrary, a numerical range recited herein includes any real number within the endpoints of the stated range and includes the endpoints thereof. As used herein, the upper and lower endpoints set forth for various numerical values may be independently combined to provide a range.

"About" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 10%, 5%, 3%, or 1% of the stated value.

As used herein, a nanoparticle is a structure having a, e.g., at least one, region or characteristic dimension with a nanoscale dimension. In an embodiment, a dimension (or an average dimension, average size, or average length) of the nanostructure is less than or equal to about 500 nm, less than or equal to about 300 nm, less than or equal to about 250 nm, less than or equal to about 150 nm, less than or equal to about 100 nm, less than or equal to about 50 nm, or less than or equal to about 30 nm. In an embodiment, the nanoparticle may have any suitable shape. The nanoparticle (e.g., a semiconductor nanoparticle or a metal oxide nanoparticle) may include a nanowire, a nanorod, a nanotube, a branched nanostructure, a nano tetrapod, a nanotripod, a nanobipod, a nanocrystal, a nanodot, a multi-pod type shape such as at least two pods, or the like and is not limited thereto. The nanoparticle can be, e.g., substantially crystalline, substantially monocrystalline, polycrystalline, (for example, at least partially) amorphous, or a combination thereof.

In an embodiment, a semiconductor nanoparticle such as a quantum dot may exhibit quantum confinement or exciton confinement. As used herein, the term "quantum dot" or "semiconductor nanostructure" is not limited in a shape thereof unless otherwise defined. A semiconductor nanoparticle or a quantum dot may have a size smaller than a Bohr excitation diameter for a bulk crystal material having an identical composition and may exhibit a quantum confinement effect. The semiconductor nanoparticle or the quantum dot may emit light corresponding to a bandgap energy thereof by controlling a size of a nanocrystal acting as an emission center.

As used herein, the term "T50" is a time (hours, hr) the brightness (e.g., luminance) of a given device decreases to 50% of the initial brightness (100%) as, e.g., when, the given device is started to be driven, e.g., operated, at a predetermined initial brightness (e.g., 650 nit).

As used herein, the term "T90" is a time (hr) the brightness (e.g., luminance) of a given device decreases to 90% of the initial brightness (100%) as the given device is started to be driven at a predetermined initial brightness (e.g., 650 nit).

As used herein, the phrase "external quantum efficiency (EQE)" is a ratio of the number of photons emitted from a light emitting diode (LED) to the number of electrons passing through the device and can be a measurement as to how efficiently a given device converts electrons to photons and allows the photons to escape. The EQE can be determined by the following equation: EQE = an efficiency of injection × a (solid-state) quantum yield × an efficiency of extraction. wherein the efficiency of injection is a proportion of electrons passing through the device that are injected into the active region, the quantum yield is a proportion of all electron-hole recombination in the active region that are radiative and produce photons, the efficiency of extraction is a proportion of photons generated in the active region that escape from the given device.

As used herein, a maximum EQE is a greatest value of the EQE.

As used herein, a maximum luminance is the highest value of luminance for a given device.

As used herein, the phrase, quantum efficiency, may be used interchangeably with the phrase, quantum yield. In an embodiment, the quantum efficiency may be a relative quantum yield or an absolute quantum yield, for example, which can be readily measured by any suitable, e.g., commercially available, equipment. The quantum efficiency (or quantum yield) may be measured in a solution state or a solid state (in a composite). In an embodiment, "quantum yield (or quantum efficiency)" may be a ratio of photons emitted to photons absorbed, e.g., by a nanostructure or population of nanostructures. In an embodiment, the quantum efficiency may be determined by any suitable method. For example, there may be two methods for measuring the fluorescence quantum yield or efficiency: the absolute method and the relative method.

The absolute method directly obtains the quantum yield by detecting all sample fluorescence through the use of an integrating sphere. In the relative method, the fluorescence intensity of a standard sample (e.g., a standard dye) may be compared with the fluorescence intensity of an unknown sample to calculate the quantum yield of the unknown sample. Coumarin 153, Coumarin 545, Rhodamine 101 inner salt, Anthracene, and Rhodamine 6G may be used as standard dye, depending on the photoluminescence (PL) wavelengths thereof, but are not limited thereto.

A bandgap energy of a semiconductor nanoparticle may vary with a size and a composition of a nanocrystal. For example, as a size of the semiconductor nanoparticle increases, the bandgap energy of the semiconductor nanoparticle may become smaller, e.g., narrower, and the semiconductor nanoparticle may emit light of, e.g., having an increased emission wavelength. A semiconductor nanocrystal may be used as a light emitting material in various fields of, e.g., such as in, a display device, an energy device, or a bio light emitting device.

A semiconductor nanoparticle-based light emitting device (hereinafter, also referred to as a QD-LED) may emit light by applying a voltage and includes a semiconductor nanoparticle or a quantum dot as a light emitting material. A QD-LED, which uses a different emission principle than an organic light emitting diode (OLED), may exhibit light emission with more desirable optical properties, e.g., higher purity, colors (e.g., red, green, and blue) and improved color reproducibility, and therefore, may be the basis for a next generation display device. A method of producing a QD-LED may include a solution process, which may lower, e.g., reduce, a manufacturing cost. In addition, semiconductor nanoparticles in a QD-LED may be based on an inorganic material, contributing to realization of increased display (light emission) stability over time.

In the QD-LED of an embodiment, holes and electrons provided from the two electrodes (e.g., a cathode and an anode) and passing through several common layers may meet and combine in the emission layer (EML, Emitting layer, QD emission layer) to form excitons resulting in light emission. In an embodiment of the QD-LED, common layers may be provided between the light emitting layer and the electrode, e.g., to facilitate injection of holes and electrons as a voltage is applied, and thus the design of these common layers may have an effect on properties (e.g., optical or stability property) of the device. For example, the electron transport layer may be required to have electron mobility enough to balance between the hole and the electron in the light emitting layer, whereby the electrons can be efficiently transferred from the electrode to the quantum dot light emitting layer. In addition, the electron transport layer may be required to have an appropriate deep HOMO energy level and sufficiently block holes coming from the quantum dot light emitting layer.

In addition, a quantum dot or a semiconductor nanoparticle exhibiting a desirable electroluminescent property may contain a harmful heavy metal such as cadmium (Cd), lead, mercury, or a combination thereof. Accordingly, it may be desirable to provide a light emitting device or a display device having a light emitting layer substantially free of such heavy metals.

In an embodiment, a light emitting device may be a device configured to emit a desired light by applying a voltage, for example, with or without a separate light source.

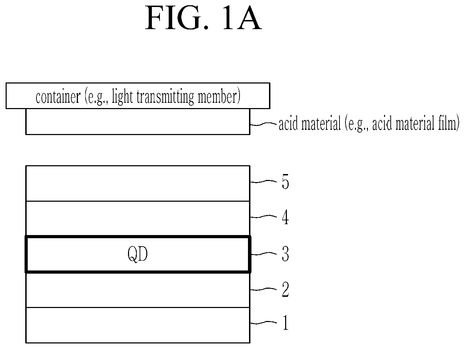

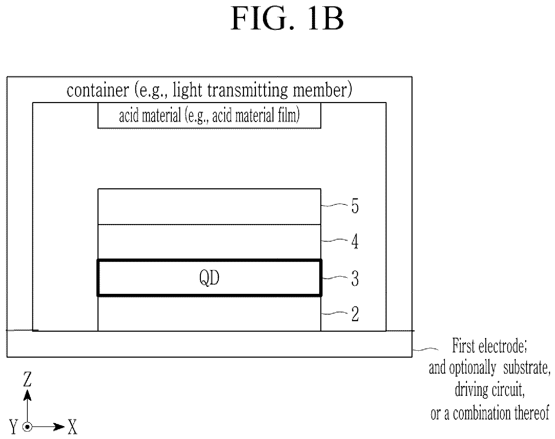

In an embodiment, a light emitting device includes a first electrode (or a hole injection conductor) 1 and a thin film conductor (e.g., electron injection conductor or second electrode, hereinafter, referred to as "second electrode") 5 spaced apart each other (e.g., each of the first electrode 1 and the thin film conductor 5 having a surface opposite the other, i.e., each with a surface facing each other); and a light emitting layer 3 disposed between the first electrode 1 and the thin film conductor 5, and an electron transport layer 4 (or an electron auxiliary layer including the same) disposed between the light emitting layer 3 and the thin film conductor 5. The electron transport layer 4 includes a metal oxide nanoparticle. The light emitting layer 3 may be configured to emit a first light when a voltage is applied (e.g., between the first electrode and the second electrode). The thin film conductor 5 may have a thickness of greater than or equal to about 1 nm or greater than or equal to about 11 nm and less than about 100 nm. In an embodiment, the light emitting device may further include a hole auxiliary layer 2 between the light emitting layer 3 and the first electrode 1. The hole auxiliary layer 2 may include a hole transport layer, a hole injection layer, or a combination thereof. The hole auxiliary layer may include an organic compound. See FIG. 1A and FIG. 1B.

The light-emitting device of an embodiment may include a metal oxide nanoparticle (for example, including a zinc oxide such as a ZnMgO, etc.) in the electron transport layer 4. The metal oxide nanoparticle can provide increased electron mobility in comparison to an organic semiconductor material. However, the present inventors have found that, in case of a light-emitting device including an electron transport layer 4 containing a metal oxide nanoparticle, a hole can easily move through defects in the metal oxide nanoparticle, resulting in a relatively high level of hole leakage current, and this can cause a decrease in efficiency from a perspective of the light-emitting device as a whole. In addition, a surface defect of the metal oxide nanoparticle can cause charging phenomenon due to the accumulation of electrical charges at an interface of the light emitting layer/electron transport layer and inside the electron transport layer 4, which can lead to a decrease in the luminance and lifespan of the light-emitting device. In summary, the metal oxide nanoparticle based electron transport layer has technological drawbacks such as a high leakage current due to defects in a metal oxide nanoparticle, a decrease in a device efficiency (a low hole blocking characteristic) resulting therefrom, a material deterioration or a lifespan reduction caused by a large amount of the charging at QD/electron transport layer interfaces and internal traps in the electron transport layer 4.

The present inventors have found that the light emitting device of an embodiment or the method of manufacturing the same can solve these technical drawbacks about the electron transport layer 4 by employing the acid material (or a layer thereof) in the manner recited herein. In the light emitting device of an embodiment or the method of manufacturing the same, an acid and moisture from the acid material can diffuse through the thin film conductor, whereby they can be utilized in manufacturing a display panel having a front common electrode covering the electron transport layer such that the electron transport layer is not exposed.

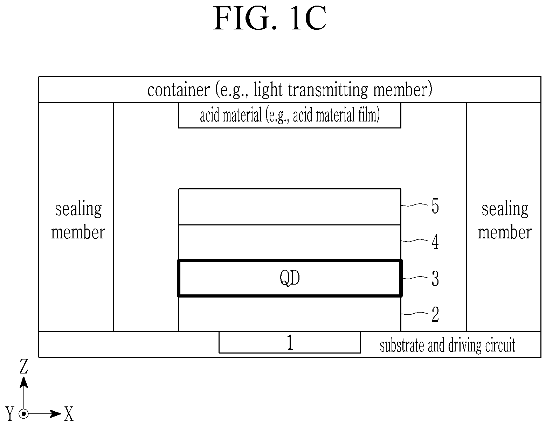

In the light emitting device of an embodiment, an acid material (for example, a polymeric acid compound; a non-polymeric acid compound such as an inorganic acid, a non-polymeric carboxylic acid compound, a non-polymeric sulfinic acid compound, or a non-polymeric sulfonic acid compound; or a combination thereof) or a film or layer of the acid material (hereinafter, can be referred to as "acid material") may be disposed on or over the electron transport layer 4 or the thin film conductor 5 (or the second electrode). (see FIG. 1A, FIG. 1B, and FIG. 1C) In the light emitting device of an embodiment, the acid material may be included as being spaced apart (in a non-contact or remote manner) from the electron transport layer 4 and the thin film conductor 5. The light emitting device of an embodiment may further include a container. The container may include a light-transmitting member, an additional member such as a sealing material, or a combination thereof. A first surface of the container may face the thin film conductor 5 (e.g., the second electrode), and the acid material may be provided on the first surface of the container to be adjacent or in contact with the container. The acid material may be in the form of a film, and the acid material may be disposed on the first surface of the container such that a first surface of the film is adjacent to the container, and a second surface opposite to the first surface of the acid material faces the thin film conductor 5 and/or the electron transport layer 4. (see FIG. 1A, FIG. 1B, and FIG. 1C)

In an embodiment, a light emitting device capable of exhibiting improved lifespan and electroluminescence characteristics (e.g., device efficiency and luminance) may be provided. The light emitting device of an embodiment can substantially block hole leakage through an electron auxiliary layer (e.g., an electron transport layer 4), exhibit increased electron transport properties, achieve improved electron-hole balance, and effectively suppress or prevent deterioration of the material due to charging.

In the light emitting device of an embodiment, the acid material may be formed from a composition having a relatively low viscosity, and may not exhibit light absorption characteristics in a predetermined wavelength range (e.g., 320 nm to 440 nm), so it can be used without limitation to the light emitting manner of the display device (e.g., can be used for both of a bottom emission type device and a top emission type device). In the light emitting device of an embodiment, the electron transport layer (ETL) can exhibit improved electron mobility, which may contribute to an improved hole-electron balance in the light emitting layer, and can efficiently transfer electrons from the electrode to the light emitting layer.

In an embodiment of the light emitting device, the electron auxiliary layer (e.g., the electron transport layer) may have a HOMO energy level having a desired depth, and the occurrence of a trap level may be suppressed, for example, effectively blocking unwanted hole movement from the light emitting layer including semiconductor nanoparticle to the second electrode.

In the light emitting device of an embodiment, the thin film conductor may also serve as a second electrode. The second electrode may include the thin film conductor. The first electrode or the second electrode may include (or may be) an anode or a cathode. In an embodiment, the first electrode may include a cathode (or anode) and the second electrode may include an anode (or cathode). In an embodiment, the second electrode includes an electron injection conductor, such as a cathode, and the first electrode includes a hole injection conductor, such as an anode.

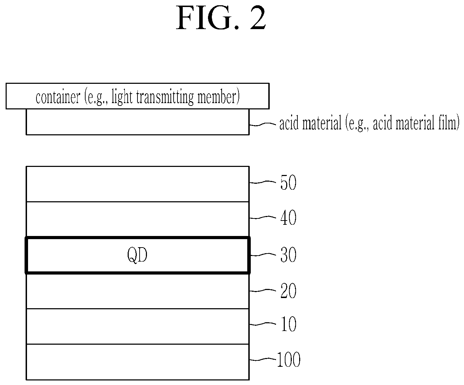

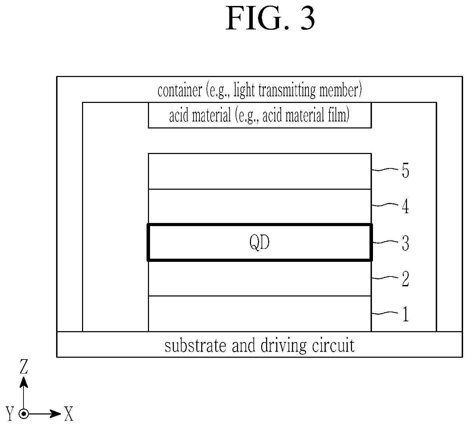

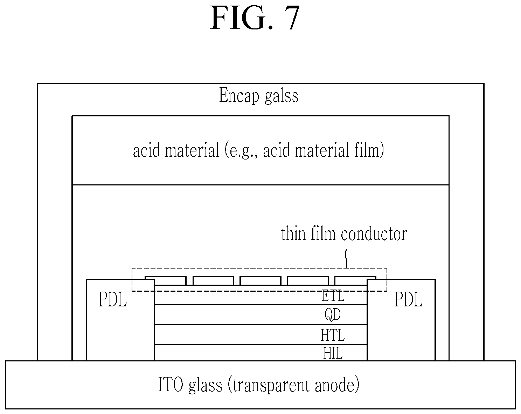

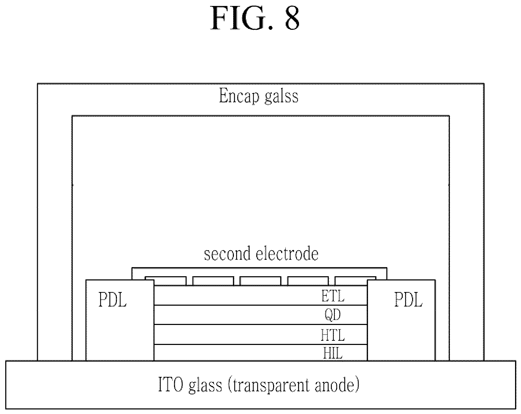

In the light emitting display device including the light emitting device of an embodiment, the first electrode may be disposed on the (transparent) substrate 100 or the substrate and the driving circuit. (see FIGS. 2 to 6) In an embodiment, the first light emitted from the light emitting layer may pass through the second electrode and the first surface of the container and be extracted (e.g., in the Z direction). In an embodiment, the first light may be extracted through the (transparent) first electrode and optionally a substrate 100 (see FIGS. 7 and 8). The light emitting layer may be disposed in a pixel (or subpixel) in the display device (display panel) to be described later.

In the light emitting device of an embodiment, a light emitting layer 3, 30 may be disposed between a first electrode (e.g., anode) 1, 10 and a second electrode (e.g., cathode) 5, 50. The cathode 5, 50 may include an electron injection conductor. The anode 1, 10 may include a hole injection conductor. The work functions of the electron/hole injection conductors included in the cathode and the anode may be appropriately adjusted and are not particularly limited. For example, the cathode may have a small work function and the anode may have a relatively large work function, or vice versa.

The electron/hole injection conductors may include a metal-based material (e.g., a metal, a metal compound, an alloy, or a combination thereof) such as aluminum, magnesium, tungsten, nickel, cobalt, platinum, palladium, calcium, LiF, etc.; a metal oxide such as gallium indium oxide or indium tin oxide (ITO); or a conductive polymer (e.g., having a relatively high work function) such as polyethylene dioxythiophene, but are not limited thereto.

The first electrode, the second electrode, or a combination thereof may be a light-transmitting electrode or a transparent electrode. In an embodiment, both the first electrode and the second electrode may be a light-transmitting electrode. The first electrode, the second electrode, or a combination thereof may be patterned electrodes.

The first electrode, the second electrode, or a combination thereof may be disposed on a (e.g., insulating) substrate 100. The substrate 100 may be a substrate including an insulating material. The substrate may include glass; various polymers such as a polyester of polyethylene terephthalate (PET), polyethylene naphthalate (PEN), and the like, polycarbonate, and polyacrylate; a polysiloxane (e.g., polydimethylsiloxane (PDMS)); an inorganic material such as Al₂O₃ or ZnO; or a combination thereof but is not limited thereto. A thickness of the substrate may be appropriately selected taking into consideration a substrate material but is not particularly limited. The substrate may be a flexible substrate. The substrate may further include an area for a blue pixel, an area for a red pixel, an area for a green pixel, or a combination thereof.

The substrate 100 or the container (or the light transmitting member included in the container) may be optically transparent. The substrate 100 or the container (or the light transmitting member) may have a light transmittance of greater than or equal to about 50%, greater than or equal to about 60%, greater than or equal to about 70%, greater than or equal to about 80%, greater than or equal to about 85%, or greater than or equal to about 90% and less than or equal to about 100%, for example, less than or equal to about 99%, or less than or equal to about 95%. The substrate or the container (or the light transmitting member included in the container) may have a transmittance of greater than or equal to about 50%, greater than or equal to about 60%, greater than or equal to about 70%, greater than or equal to about 80%, greater than or equal to about 85%, greater than or equal to about 90%, greater than or equal to about 95%, or greater than or equal to about 99%, and less than or equal to about 100%, for example, less than or equal to about 99%, or less than or equal to about 95%, with respect to the light emitted from the semiconductor nanoparticle for example included in the light emitting layer. In an embodiment, the substrate or the container (or the light-transmitting member) may be opaque or reflective.

In an embodiment, a thin film transistor may be disposed in each region of the substrate, but it is not limited thereto. In an embodiment, a source electrode or a drain electrode of the thin film transistor may be electrically connected to the first electrode or the second electrode. In an embodiment, the light-transmitting electrode may be disposed on a (e.g., insulating) transparent substrate. The substrate 100 may be a rigid or a flexible substrate.

The electrode may include or be made of, for example, a metal oxide such as an indium tin oxide (ITO) or an indium zinc oxide (IZO), a gallium indium tin oxide, a zinc indium tin oxide; a metal nitride such as a titanium nitride; a conductive polymer such as a polyaniline; LiF/Mg:Ag; a metal thin film of a single layer or a plurality of layers; or a combination thereof. In an embodiment, the electrode (e.g., the first electrode and/or the second electrode) may include aluminum (Al), a lithium-aluminum (Li:Al) alloy, a magnesium-silver (Mg:Ag) alloy, lithium fluoride-aluminum (LiF:Al), gold, silver, or a combination thereof. A ratio of the alloy may be appropriately selected and is not particularly limited. The electrode may be formed by vacuum deposition, thermal deposition, sputtering deposition, or the like.

A thickness of each of the electrode (the first electrode, the second electrode, or a combination thereof) is not particularly limited and may be appropriately selected taking into consideration device efficiency. For example, the thickness of the electrode (or the thin film conductor) may be greater than or equal to about 5 nm, greater than or equal to about 10 nm, greater than or equal to about 20 nm, greater than or equal to about 30 nm, greater than or equal to about 40 nm, or greater than or equal to about 50 nm. For example, the thickness of the electrode (or the thin film conductor) may be less than or equal to about 100 micrometers (µm), less than or equal to about 90 µm, less than or equal to about 80 µm, less than or equal to about 70 µm, less than or equal to about 60 µm, less than or equal to about 50 µm, less than or equal to about 40 µm, less than or equal to about 30 µm, less than or equal to about 20 µm, less than or equal to about 10 µm, less than or equal to about 1 µm, less than or equal to about 900 nm, less than or equal to about 500 nm, or less than or equal to about 100 nm.

A light transmitting electrode or a non-light transmitting or non-transmissive electrode (e.g., a reflective electrode) may be formed by adjusting the composition and/or thickness of the electrode. In an embodiment, the non-transmissive electrode may include a metal layer (e.g., aluminum, silver, or the like) disposed between layers of a metal oxide (e.g., light-transmitting metal oxide) such as an indium tin oxide. In an embodiment, the light-transmitting electrode may include a light-transmitting metal oxide, a thin metal or alloy thin film, or a combination thereof. The light-transmitting electrode may include a transparent electrode and a translucent electrode.

In the light emitting device of an embodiment, the second electrode or the thin film conductor may have a thickness of greater than or equal to about 1 nm, for example, greater than or equal to about 5 nm, greater than or equal to about or 9 nm and less than 100 nm, less than or equal to about 99 nm, or less than or equal to about 95 nm. The thickness of the second electrode or thin film conductor may be greater than about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, or greater than or equal to about 20 nm. The thin film conductor may have a thickness of less than or equal to about 80 nm, less than or equal to about 60 nm, less than or equal to about 50 nm, or less than or equal to about 40 nm.

In the light emitting device of an embodiment, the first electrode, the second electrode or the thin film conductor may have a light transmittance for the first light that is greater than or equal to about 20%, greater than or equal to about 25%, greater than or equal to about 30%, greater than or equal to about 35%, greater than or equal to about 40%, greater than or equal to about 45%, greater than or equal to about 50%, greater than or equal to about 55%, greater than or equal to about 57%, greater than or equal to about 59%, greater than or equal to about 60%, greater than or equal to about 63%, greater than or equal to about 65%, greater than or equal to about 67%, greater than or equal to about 69%, greater than or equal to about 70%, greater than or equal to about 75%, greater than or equal to about 78%, greater than or equal to about 80%, greater than or equal to about 82%, greater than or equal to about 85%, or greater than or equal to about 89%. The light transmittance for the first light may be less than or equal to about 100%, less than or equal to about 99%, less than or equal to about 98%, less than or equal to about 97%, less than or equal to about 96%, less than or equal to about 95%, less than or equal to about 94%, less than or equal to about 93%, less than or equal to about 92%, less than or equal to about 91%, less than or equal to about 90%, less than or equal to about 89%, less than or equal to about 88%, less than or equal to about 87%, less than or equal to about 86%, less than or equal to about 85%, less than or equal to about 84%, less than or equal to about 83%, less than or equal to about 82%, less than or equal to about 80%, less than or equal to about 79%, less than or equal to about 76%, less than or equal to about 73%, less than or equal to about 68%, less than or equal to about 66%, less than or equal to about 64%, less than or equal to about 61%, less than or equal to about 60%, less than or equal to about 55%, less than or equal to about 50%, less than or equal to about 49%, less than or equal to about 48%, or less than or equal to about 47%.

In an embodiment of the light emitting device, the second electrode or the first electrode may be configured to reflect at least a portion (e.g., greater than or equal to about 50%, greater than or equal to about 60%, greater than or equal to about 70%, greater than or equal to about 80%, greater than or equal to about 90%, greater than or equal to about 95%, or greater than or equal to about 99%) of the first light. In an embodiment of the light emitting device, the second electrode or the first electrode may include a multi-layered structure, for example, having a structure of ITO/aluminum/ITO, ITO/Ag/ITO, Ag/ITO; a conductive metal electrode such as Ag, Al, Cu, Au, tungsten, nickel, cobalt, platinum; or a combination thereof.

The thin film conductor may include silver, aluminum, magnesium, tungsten, nickel, cobalt, platinum, palladium, calcium, LiF, gold, copper, or a combination thereof (e.g., alloy thereof). The thin film conductor may include silver and magnesium, an alloy thereof, aluminum and magnesium, or an alloy thereof, or a combination thereof. The thin film conductor or the second electrode may be an electrode that can be formed by a thermal deposition. In an embodiment, the thin film conductor may exhibit a metal pore and/or a grain boundary in its cross-sectional view obtained by using a microscope or an electron microscope. In an embodiment, the thin film conductor may not exhibit a metal pore and/or a grain boundary in its cross-sectional view obtained by using a microscope or an electron microscope.

In the light emitting device of an embodiment and the method of manufacturing the same, the thin film conductor may exhibit conductivity sufficient to serve as an electrode, and at the same time, the acid and moisture supplied from the acid material (or a film thereof) may pass through the thin film conductor and reach the electron transport layer including a metal oxide nanoparticle, under the post-treatment conditions described herein. The acid and the moisture reaching the electron transport layer may modify a surface of the metal oxide nanoparticle, whereby a hydrogen ion (H+) and a hydroxide ions (OH-) may be supplied to the metal oxide nanoparticle in the electron transport layer to passivate a surface defect through a chemical reaction. The inclusion of the post-treated electron transport layer in the light emitting device of an embodiment can reduce hole leakage current, which can be confirmed by a lower driving voltage and a higher efficiency of the device than the device prior to the post treatment. The inclusion of the post-treated electron transport layer in the light emitting device of an embodiment can increase the hole blocking performance and electron mobility of the electron transport layer, and this can contribute to the improvement of the brightness of the device. The inclusion of the post-treated electron transport layer in the light emitting device of an embodiment may alleviate a charging phenomenon at an interface between the light emitting layer and the electron transport layer, and the device of an embodiment may exhibit a reduced interfacial degradation and an increased lifespan.

The light emitting layer 3, 30 may be disposed between the first electrode 1 and the second electrode 5 (e.g., the anode 1, 10 and the cathode 5, 50) and may include a semiconductor nanoparticle (e.g., blue light emitting nanoparticles, red light emitting nanoparticles, green light emitting nanoparticles, or a combination thereof). The light emitting layer may include one or more (e.g., 2 or more or 3 or more and 10 or less) monolayers of the plurality of semiconductor nanoparticles.

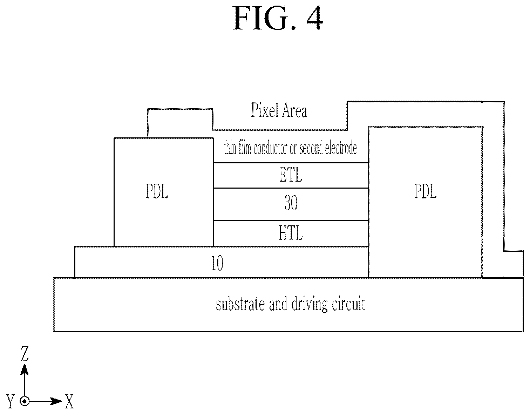

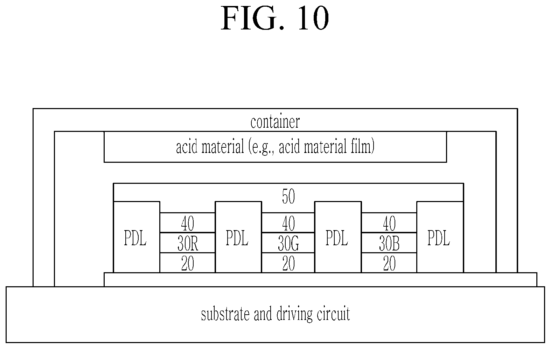

The light emitting layer may be patterned. In an embodiment, the patterned light emitting layer may include a blue light emitting layer disposed in the blue pixel, a red light emitting layer disposed in the red pixel, a green light emitting layer disposed in the green pixel, or a combination thereof. In an embodiment, the light emitting layer may include a red light emitting layer disposed in the red pixel and a green light emitting layer disposed in the green pixel. Each of the (e.g., red, green, or blue) light emitting layers may be (e.g., optically) separated from an adjacent light emitting layer by a partition wall. In an embodiment, partition walls or banks (e.g., black matrices or pixel defining layers) may be disposed between the red light emitting layer, the green light emitting layer, and the blue light emitting layer (see FIG. 4 to FIG. 8, FIG. 10). In an embodiment, the red light emitting layer, the green light emitting layer, and the blue light emitting layer may be optically isolated from each other.

In an embodiment, the light emitting layer 3, 30 or the semiconductor nanoparticle may not include cadmium. In an embodiment, the light emitting layer 3, 30 or the semiconductor nanoparticle may not include mercury, lead, or a combination thereof.

In an embodiment, the semiconductor nanoparticle may have a core-shell structure. In an embodiment, the semiconductor nanoparticle or the core-shell structure may include a core including a first semiconductor nanocrystal and a shell disposed on the core and including a second semiconductor nanocrystal having a composition different from that of the first semiconductor nanocrystal.

The semiconductor nanoparticle (or the first semiconductor nanocrystal, the second semiconductor nanocrystal, or a combination thereof) may include a Group II-VI compound, a Group III-V compound, a Group IV-VI compound, a Group IV element or compound, a Group I-III-VI compound, a Group II-III-VI compound, a Group I-II-IV-VI compound, or a combination thereof. In an embodiment, the light emitting layer or the semiconductor nanoparticle (e.g., the first semiconductor nanocrystal or the second semiconductor nanocrystal) may not include cadmium. In an embodiment, the light emitting layer or the semiconductor nanoparticle (e.g., the first semiconductor nanocrystal or the second semiconductor nanocrystal) may not include lead. In an embodiment, the light emitting layer or the semiconductor nanoparticle (e.g., the first semiconductor nanocrystal or the second semiconductor nanocrystal) may not include a combination of lead and cadmium.

The Group II-VI compound may be a binary element compound such as ZnS, ZnSe, ZnTe, ZnO, HgS, HgSe, HgTe, MgSe, MgS, or a combination thereof; a ternary element compound such as ZnSeS, ZnSeTe, ZnSTe, HgSeS, HgSeTe, HgSTe, HgZnS, HgZnSe, HgZnTe, MgZnSe, MgZnS, or a combination thereof; a quaternary element compound such as HgZnTeS, HgZnSeS, HgZnSeTe, HgZnSTe, or a combination thereof; or a combination thereof. The Group II-VI compound may further include a Group III metal.

The Group III-V compound may be a binary element compound such as GaN, GaP, GaAs, GaSb, AlN, AlP, AlAs, AlSb, InN, InP, InAs, InSb, or a combination thereof; a ternary element compound such as GaNP, GaNAs, GaNSb, GaPAs, GaPSb, AlNP, AlNAs, AlNSb, AlPAs, AlPSb, InNP, InNAs, InNSb, InPAs, InPSb, or a combination thereof; a quaternary element compound such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, or a combination thereof; or a combination thereof. The Group III-V compound may further include a Group II metal (e.g., InZnP).

The Group IV-VI compound may be a binary element compound such as SnS, SnSe, SnTe, PbS, PbSe, PbTe, or a combination thereof; a ternary element compound such as SnSeS, SnSeTe, SnSTe, PbSeS, PbSeTe, PbSTe, SnPbS, SnPbSe, SnPbTe, or a combination thereof; a quaternary element compound such as SnPbSSe, SnPbSeTe, SnPbSTe, or a combination thereof; or a combination thereof.

Examples of the Group I-III-VI compound may be CuInSe₂, CuInS₂, CuInGaSe, and CuInGaS, but are not limited thereto.

Examples of the Group I-II-IV-VI compound may be CuZnSnSe, and CuZnSnS, but are not limited thereto. Examples of I-III-VI semiconductor compounds may include a ternary element compound such as AgInS, AgInS₂, AgInSe₂, AgGaS, AgGaS₂, AgGaSe₂, CuInS, CuInS₂, CuInSe₂, CuGaS₂, CuGaSe₂, CuGaO₂, AgGaO₂, or AgAlO₂; a quaternary element compound such as AgInGaS₂, AgInGaSe₂; or a combination thereof.

Examples of the Group I-II-IV-VI compound include, but are not limited to, CuZnSnSe and CuZnSnS.

The Group IV element or compound may include a single-element such as Si, Ge, or a combination thereof; a binary element compound such as SiC, SiGe, or a combination thereof; or a combination thereof.

Each element included in a multi-element compound such as a binary element compound, a ternary element compound, or a quaternary element compound may be present in the particle at a uniform concentration or at a nonuniform concentration. For example, the chemical formula described above means the types of elements included in the compound, and the stoichiometries among the elements in the compound may be different the recited chemical formula. For example, the chemical formula "AgInGaS₂" may include AgInₓGa₁₋ₓS₂ (x is a real number of greater than 0 and less than or equal to 1), but is not limited thereto.

In an embodiment, the semiconductor nanoparticle or the first semiconductor nanocrystal may include a metal including indium, zinc, or a combination thereof and a non-metal including phosphorus, selenium, tellurium, sulfur, or a combination thereof. In an embodiment, the second semiconductor nanocrystal may include a metal including indium, zinc, or a combination thereof, and a non-metal including phosphorus, selenium, tellurium, sulfur, or a combination thereof.

In an embodiment, a first semiconductor nanocrystal may include InP, InZnP, ZnSe, ZnSeS, ZnSeTe, or a combination thereof; the second semiconductor nanocrystal may include ZnSe, ZnSeS, ZnS, ZnTeSe, or a combination thereof. In an embodiment, the shell may include zinc, sulfur, and optionally selenium in the outermost layer.

In an embodiment, the semiconductor nanoparticle may emit blue or green light and may include a core including ZnSeTe, ZnSe, or a combination thereof and a shell including a zinc chalcogenide (e.g., ZnS, ZnSe, ZnSeS, or a combination thereof). An amount of sulfur in the shell may increase or decrease in a radial direction (from the core toward the surface), e.g., the amount of sulfur may have a concentration gradient wherein the concentration of sulfur varies radially (e.g., decreases or increases in a direction toward the core).

In an embodiment, the semiconductor nanoparticle may emit red or green light, the core may include InP, InZnP, or a combination thereof, and the shell may include a Group II metal including zinc and a non-metal including sulfur, selenium, or a combination thereof.

In an embodiment, as the semiconductor nanoparticle has a core-shell structure, on the interface between the core and the shell, an alloyed interlayer may be present or may not be present. The alloyed interlayer layer may include a homogeneous alloy or may have a concentration gradient. The gradient alloy may have a concentration gradient wherein the concentration of an element of the shell varies radially (e.g., decreases or increases in a direction toward the core).

In an embodiment, the shell may have a composition that varies in a radial direction. In an embodiment, the shell may be a multilayered shell including two or more layers. In a multilayered shell, adjacent two layers may have different compositions from each other. In a multilayered shell, a, e.g., at least one, layer may independently include a semiconductor nanocrystal having a single composition. In a multilayered shell, a, e.g., at least one, layer may independently have an alloyed semiconductor nanocrystal. In a multilayered shell, a, e.g., at least one, layer may have a concentration gradient that varies radially in terms of a composition of a semiconductor nanocrystal.

In an embodiment, in a semiconductor nanoparticle having a core-shell structure, a shell material may have a bandgap energy that is larger, e.g., greater, than that of the core. The materials of the shell may have a bandgap energy that is smaller, e.g., less, than that of the core. In the case of a multilayered shell, the bandgap energy of the outermost layer material of the shell may be greater than the bandgap energies of the core and the inner layer material of the shell (layers that are closer to the core). In the case of a multilayered shell, a semiconductor nanocrystal of each layer is selected to have an appropriate bandgap, thereby effectively showing, e.g., exhibiting, a quantum confinement effect.

The semiconductor nanoparticle according to an embodiment may include, for example, an organic ligand which is bonded or coordinated to a surface thereof.

An absorption/emission wavelength of the semiconductor nanoparticle may be controlled by adjusting the compositions, sizes, or a combination thereof of the semiconductor nanoparticle. The semiconductor nanoparticle included in the light emitting layer 3, 30 may be configured to emit light of a desired color. The semiconductor nanoparticle may include a blue light emitting semiconductor nanoparticle, a green light emitting semiconductor nanoparticle, or a red light emitting semiconductor nanoparticle.

In an embodiment, a maximum emission peak wavelength of the semiconductor nanoparticle or a light emission layer (or the light emitted from the electroluminescent device) may be in a wavelength range of from ultraviolet to infrared. In an embodiment, a maximum emission peak wavelength of the semiconductor nanoparticle or the light emitting layer (or the light emitted from the electroluminescent device) may be greater than or equal to about 300 nm, greater than or equal to about 500 nm, greater than or equal to about 510 nm, greater than or equal to about 520 nm, greater than or equal to about 530 nm, greater than or equal to about 540 nm, greater than or equal to about 550 nm, greater than or equal to about 560 nm, greater than or equal to about 570 nm, greater than or equal to about 580 nm, greater than or equal to about 590 nm, greater than or equal to about 600 nm, or greater than or equal to about 610 nm. The maximum emission peak wavelength of the semiconductor nanoparticle or a light emission layer (or the light emitted from the electroluminescent device) may be less than or equal to about 900 nm, less than or equal to about 800 nm, less than or equal to about 650 nm, less than or equal to about 640 nm, less than or equal to about 630 nm, less than or equal to about 620 nm, less than or equal to about 610 nm, less than or equal to about 600 nm, less than or equal to about 590 nm, less than or equal to about 580 nm, less than or equal to about 570 nm, less than or equal to about 560 nm, less than or equal to about 550 nm, or less than or equal to about 540 nm. The maximum emission peak wavelength of the semiconductor nanoparticle or a light emission layer (or the light emitted from the electroluminescent device) may be in a range of a green light or red light wavelength, for example, in a range of greater than or equal to about 490 nm or greater than or equal to about 500 nm to less than or equal to about 660 nm or less than or equal to about 650 nm.

The semiconductor nanoparticle (or the light emitted from the electroluminescent device) may emit green light (for example, on an application of a voltage or irradiation with light) and a maximum emission peak wavelength thereof may be in the range of greater than or equal to about 500 nm (for example, greater than or equal to about 510 nm, or greater than or equal to about 515 nm) and less than or equal to about 560 nm, for example, less than or equal to about 540 nm. The semiconductor nanoparticle (or the light emitted from the electroluminescent device) may emit red light, (for example, on an application of voltage or irradiation with light), and a maximum emission peak wavelength thereof may be in the range of greater than or equal to about 600 nm, for example, greater than or equal to about 610 nm and less than or equal to about 650 nm, or less than or equal to about 640 nm.

The semiconductor nanoparticle (or the light emitted from the electroluminescent device) may emit blue light, (for example, on an application of voltage or irradiation with light) and a maximum emission peak wavelength thereof may be greater than or equal to about 430 nm, greater than or equal to about 440 nm (for example, greater than or equal to about 450 nm, greater than or equal to about 455 nm, greater than or equal to about 460 nm, greater than or equal to about 465 nm) and less than or equal to about 480 nm (for example, less than or equal to about 475 nm, less than or equal to about 470 nm, or less than or equal to about 465 nm).

In an embodiment, the semiconductor nanoparticle may exhibit a luminescent spectrum (e.g., photo- or electro- luminescent spectrum) with a relatively narrow full width at half maximum. In an embodiment, in the photo-or electro- luminescent spectrum, the semiconductor nanoparticle may exhibit a full width at half maximum of less than or equal to about 45 nm, less than or equal to about 44 nm, less than or equal to about 43 nm, less than or equal to about 42 nm, less than or equal to about 41 nm, less than or equal to about 40 nm, less than or equal to about 39 nm, less than or equal to about 38 nm, less than or equal to about 37 nm, less than or equal to about 36 nm, or less than or equal to about 35 nm. The full width at half maximum may be greater than or equal to about 10 nm, greater than or equal to about 15 nm, greater than or equal to about 20 nm, or greater than or equal to about 25 nm.

The semiconductor nanoparticle may exhibit (or may be configured to exhibit) a quantum efficiency (or quantum yield) of greater than or equal to about 10%, for example, greater than or equal to about 30%, greater than or equal to about 50%, greater than or equal to about 60%, greater than or equal to about 70%, greater than or equal to about 80%, greater than or equal to about 90%, or about 100%.

The semiconductor nanoparticle may have a size (or an average size, hereinafter, can be simply referred to as "size") of greater than or equal to about 1 nm and less than or equal to about 100 nm. The size may be a diameter or equivalent diameter converted by assuming a spherical shape from an electron microscope image when not spherical. The size may be calculated from a result of an inductively coupled plasma atomic emission spectroscopy (ICP-AES) analysis. In an embodiment, the semiconductor nanoparticle may have a size of from about 1 nm to about 50 nm, for example, from about 2 nm (or about 3 nm) to about 35 nm. In an embodiment, a size (or an average size) of the semiconductor nanoparticle may be greater than or equal to about 3 nm, greater than or equal to about 4 nm, greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, or greater than or equal to about 12 nm. In an embodiment, a size (or an average size) of the semiconductor nanoparticle may be less than or equal to about 50 nm, less than or equal to about 40 nm, less than or equal to about 30 nm, less than or equal to about 25 nm, less than or equal to about 20 nm, less than or equal to about 19 nm, less than or equal to about 18 nm, less than or equal to about 17 nm, less than or equal to about 16 nm, less than or equal to about 15 nm, less than or equal to about 14 nm, less than or equal to about 13 nm, or less than or equal to about 12 nm.

The shape of the semiconductor nanoparticle or the semiconductor nanostructure is not particularly limited. For example, the shape of the semiconductor nanoparticle may include, but is not limited to, a sphere, a polyhedron, a pyramid, a multi-pod shape, a hexahedron, a cube, a cuboid, a nanotube, a nanorod, a nanowire, a nanosheet, or a combination thereof.

The semiconductor nanoparticle may be prepared in an appropriate method. The semiconductor nanoparticle may be prepared for example by a chemical wet method wherein a nanocrystal particle may grow by a reaction between precursors in a reaction system including an organic solvent and an organic ligand. The organic ligand or the organic solvent may coordinate (with or to) a surface of the semiconductor nanocrystal to control the growth thereof.

In an embodiment, for example, the method of preparing the semiconductor nanoparticle having a core/shell structure may include obtaining the core; reacting a first shell precursor including a metal (e.g., zinc) and a second shell precursor including a non-metal element (e.g., selenium, sulfur, or a combination thereof) in the presence of the core in a reaction medium including an organic ligand and an organic solvent at a reaction temperature (e.g., of greater than or equal to about 180 °C, greater than or equal to about 200 °C, greater than or equal to about 240 °C, or greater than or equal to about 280 °C and less than or equal to about 360°C, less than or equal to about 340 °C, or less than or equal to about 320 °C) to form a shell including a second semiconductor nanocrystal on a core including a first semiconductor nanocrystal. In the semiconductor nanoparticle of an embodiment, the core may be prepared in an appropriate manner. The method may further include separating a core from a reaction system producing the same and dispersing the core in an organic solvent to obtain a core solution.

In an embodiment, in order to form the shell, a solvent and optionally a ligand compound may be heated at a predetermined temperature (e.g., greater than or equal to about 100 °C) under vacuum (also referred to herein as vacuum-treated) and then, after introducing an inert gas into the reaction vessel, the mixture may be heat-treated again at a predetermined temperature (e.g., greater than or equal to 100 °C). Then, the core and the shell precursors may be added to the mixture and heated at a reaction temperature. The shell precursors may be added at different ratios during a reaction time simultaneously or sequentially.

In an embodiment, the organic solvent may include a C6 to C22 primary amine such as a hexadecylamine, a C6 to C22 secondary amine such as dioctylamine, a C6 to C40 tertiary amine such as a trioctyl amine, a nitrogen-containing heterocyclic compound such as pyridine, a C6 to C40 olefin such as octadecene, a C6 to C40 aliphatic hydrocarbon such as hexadecane, octadecane, or squalane, an aromatic hydrocarbon substituted with a C6 to C30 alkyl group such as phenyldodecane, phenyltetradecane, or phenyl hexadecane, a primary, secondary, or tertiary phosphine (e.g., trioctyl phosphine) substituted with a, e.g., at least one (e.g., 1, 2, or 3), C6 to C22 alkyl group, a phosphine oxide (e.g., trioctylphosphine oxide) substituted with a (e.g., 1, 2, or 3) C6 to C22 alkyl group, a C12 to C22 aromatic ether such as phenyl ether or benzyl ether, or a combination thereof.

The organic ligand may include RCOOH, RNH₂, R₂NH, R₃N, RSH, RH₂PO, R₂HPO, RsPO, RH₂P, R₂HP, R₃P, ROH, RCOOR', RPO(OH)₂, R₂POOH or a combination thereof. Herein, R and R' are each independently a substituted or unsubstituted, C3 or greater, C6 or greater, or C10 or greater and about C40 or less, C35 or less, or C25 or less, aliphatic hydrocarbon group (e.g., alkyl, alkenyl, alkynyl, etc.), a substituted or unsubstituted C6 to C40 aromatic hydrocarbon group (e.g., aryl group), or a combination thereof. In an embodiment, at least two different organic ligands may be used.

In an embodiment, after completing the reaction (for the formation of the core or for the formation of the shell), a nonsolvent is added to reaction products and a nanoparticle coordinated with the ligand compound may be separated. The nonsolvent may be a polar solvent that is miscible with the solvent used in the core formation reactions, shell formation reaction, or a combination thereof and is not capable of dispersing the prepared nanocrystals. The nonsolvent may be selected depending on the solvent used in the reaction and may include, for example, acetone, ethanol, butanol, isopropanol, ethanediol, water, tetrahydrofuran (THF), dimethylsulfoxide (DMSO), diethylether, formaldehyde, acetaldehyde, a solvent having a similar solubility parameter to the foregoing non-solvents, or a combination thereof. The semiconductor nanocrystal particles may be separated through centrifugation, sedimentation, or chromatography. The separated nanocrystals may be washed with a washing solvent, if desired. The washing solvent has no particular limit and may have a similar solubility parameter to that of the ligand and may, for example, include hexane, heptane, octane, chloroform, toluene, benzene, and the like.

The semiconductor nanoparticles of an embodiment may be non-dispersible or insoluble in water, the aforementioned nonsolvent, or a combination thereof. The semiconductor nanoparticles of an embodiment may be dispersed in the aforementioned organic solvent. In an embodiment, the aforementioned semiconductor nanoparticles may be dispersed in a substituted or unsubstituted C6 to C40 aliphatic hydrocarbon, a substituted or unsubstituted C6 to C40 aromatic hydrocarbon, or a combination thereof.

The prepared semiconductor nanoparticles may be treated with a halogen compound. By the treatment with the halogen compound, at least a portion of the organic ligand may be replaced with the halogen. The halogen treated semiconductor nanoparticles may include a reduced amount of the organic ligand. The halogen treatment may be carried out contacting the semiconductor nanoparticles with the halogen compound (e.g., a metal halide such as a zinc chloride) at a predetermined temperature of from about 30 °C to about 100 °C or from about 50 °C to about 150 °C in an organic solvent. The halogen-treated semiconductor nanoparticles may be separated using the nonsolvent described above.

In the light emitting device or the display device of an embodiment, a thickness of the light emitting layer may be appropriately selected. In an embodiment, the light emitting layer may include a monolayer of nanoparticles. In an embodiment, the light emitting layer may include one or more, for example, two or more, three or more, or four or more and 20 or less, 10 or less, 9 or less, 8 or less, 7 or less, or 6 or less monolayers of nanoparticles. The light emitting layer may have a thickness of greater than or equal to about 5nm, for example, greater than or equal to about 10 nm, greater than or equal to about 20 nm, or greater than or equal to about 30 nm and less than or equal to about 200 nm, less than or equal to about 150 nm, less than or equal to about 100 nm, less than or equal to about 90 nm, less than or equal to about 80 nm, less than or equal to about 70 nm, less than or equal to about 60 nm, or less than or equal to about 50 nm. The light emitting layer may have a thickness of, for example, about 10 nm to about 150 nm, about 20 nm to about 100 nm, or about 30 nm to about 50 nm.

In an embodiment, the forming of the light emitting layer including the semiconductor nanoparticles may be performed by obtaining a coating liquid including semiconductor nanoparticles and an organic solvent (e.g., an alkane solvent such as octane, heptane, or the like, an aromatic solvent such as toluene, or a combination thereof) and applying or depositing the coating liquid on a substrate or charge auxiliary layer (e.g., a hole auxiliary layer) in an appropriate manner (e.g., by spin coating, inkjet printing, etc.). A type of the organic solvent for the coating liquid is not particularly limited and may be selected appropriately. In an embodiment, the organic solvent may include a substituted or unsubstituted aliphatic hydrocarbon, a substituted or unsubstituted aromatic hydrocarbon, a substituted or unsubstituted alicyclic hydrocarbon, an acetate solvent, or a combination thereof.

In an embodiment, the formation of the light emitting layer may further include contacting the film of the semiconductor nanoparticles with a metal halide (e.g., a zinc chloride)-containing organic solution (e.g., including an alcohol solvent). In an embodiment, the light emitting layer may include a first light emitting layer including a first semiconductor nanoparticle and a second light emitting layer including a second semiconductor nanoparticle, wherein the first semiconductor nanoparticle has a halogen (e.g., chlorine) exchanged surface and the second light emitting layer has an increased amount of an organic ligand. A halogen (e.g., chlorine) amount and an organic ligand amount of the light emitting layer may be controlled with an appropriate manner (e.g., a post treatment for the formed layer). In an embodiment, a thin film of the semiconductor nanoparticles having an organic ligand (e.g., having a carboxylic acid group) is formed, which is then treated with a solution including a metal halide (e.g., a zinc halide such as a zinc chloride in alcohol solvent) to control an amount of the organic ligand of the semiconductor nanoparticles in the thin film. The treated thin film may have an increased halogen amount, showing, e.g., exhibiting, a changed property (e.g., solubility) to, e.g., relative to, an organic solvent, and it may be possible to form a layer of semiconductor nanoparticles having a different amount of an organic ligand (e.g., a halogen treated semiconductor nanoparticle or a semiconductor nanoparticle with a ligand having a carboxylic acid group) on the treated thin film, subsequently.

In an embodiment, the light emitting layer may be a single layer or a multi-layered structure having at least two layers. In a multi-layered structure, adjacent layers (e.g., a first light emitting layer and a second light emitting layer) may be configured to emit a first light (e.g., green light, blue light, or red light). In a multi-layered structure, adjacent layers (e.g., a first light emitting layer and a second light emitting layer) may have the same or different composition, ligands, or a combination thereof. In an embodiment, the (multi-layered) light emitting layer may exhibit a halogen content that varies (increase or decrease) in a thickness direction. In an embodiment, in the (multi-layered) light emitting layer, the amount of the halogen may increase in a direction toward the electron auxiliary layer. In the (multi-layered) light emitting layer, the amount of the organic ligand may decrease in a direction toward the electron auxiliary layer. In the (multi-layered) light emitting layer, the content of the organic ligand may increase in a direction toward the electron auxiliary layer.

In an embodiment, the light emitting layer thus formed (or treated with the halogen solution) may be washed with an organic washing solvent (water or an organic solvent miscible with the water). A manner of the washing is not particularly limited and may be conducted by a spin and dry, a dipping, or a combination thereof.

The light emitting layer may be heat-treated. The heat treating may be carried out in air or in an inert gas atmosphere. A temperature of the heat treating may be greater than or equal to about 50 °C, greater than or equal to about 70 °C, greater than or equal to about 90 °C, greater than or equal to about 100 °C, greater than or equal to about 120 °C, greater than or equal to about 150°C, greater than or equal to about 170 °C, or greater than or equal to about 200 °C. A temperature of the heat treating may be less than or equal to about 250 °C, less than or equal to about 230 °C, less than or equal to about 200 °C, less than or equal to about 180 °C, less than or equal to about 160 °C, less than or equal to about 140 °C, or less than or equal to about 130 °C.

The light emitting device of an embodiment includes an electron auxiliary layer 4, 40 disposed on the light emitting layer 3, 30, for example, between the light emitting layer and the thin film conductor or the second electrode 5, 50. In the electron auxiliary layer 4, 40, transporting, injecting, or transporting and injecting of electrons may occur. The electron auxiliary layer 4, 40 includes an electron transport layer (ETL). The electron transport layer includes a metal oxide nanoparticle. The electron auxiliary layer 4, 40 may further include an electron injection layer, a hole blocking layer, or a combination thereof. The electron injection layer, the hole blocking layer, or a combination thereof may be disposed between the electron transport layer and the second electrode, but it is not limited thereto. In an embodiment, the hole blocking layer may be disposed between the electron injection layer and the electron transport layer. In an embodiment, the electron injection layer may be disposed between the hole blocking layer and the electron transport layer. The electron transport layer may be adjacent (e.g., directly adjacent or directly disposed on) the light emitting layer. In an embodiment, the light emitting layer 3, 30 may contact the electron transport layer.

The second electrode 5, 50 may have a first surface facing a surface of the electron transport layer (or the electron auxiliary layer) and a second surface opposite to the first surface. The metal oxide (nanoparticle) may include a zinc oxide. The metal oxide (nanoparticle) or the zinc oxide may include zinc; and optionally a Group IIA metal, Zr, W, Li, Ti, Y, Al, gallium, indium, tin (Sn), cobalt (Co), vanadium (V), or a combination thereof. In an embodiment, the metal oxide (nanoparticle) or the zinc oxide may include zinc, a Group IIA metal, and optionally an alkali metal.

The metal oxide (nanoparticle) or the zinc oxide may include a compound represented by Zn₁₋ₓ MₓO, wherein, M is Mg, Ca, Zr, Co, W, Li, Ti, Y, Al, or a combination thereof, and 0 ≤ x ≤ 0.5. The x may be greater than or equal to about 0.01, greater than or equal to about 0.03, greater than or equal to about 0.05, greater than or equal to about 0.07, greater than or equal to about 0.1, greater than or equal to about 0.13, greater than or equal to about 0.15, greater than or equal to about 0.17, greater than or equal to about 0.2, greater than or equal to about 0.23, or greater than or equal to about 0.25. The x may be less than or equal to about 0.47, less than or equal to about 0.45, less than or equal to about 0.43, less than or equal to about 0.4, less than or equal to about 0.37, less than or equal to about 0.35, or less than or equal to about 0.3. The metal oxide or the zinc oxide may further include magnesium. The electron transport layer or the zinc oxide may include Zn₁₋ₓMgₓO (x is greater than or equal to 0, or greater than 0 and less than or equal to about 0.5, the x is the same as defined herein), ZnO, or a combination thereof. The zinc oxide may further include magnesium.

A size or an average size (hereinafter, referred to as "size") of the metal oxide nanoparticle may be greater than or equal to about 1 nm, greater than or equal to about 2 nm, greater than or equal to about 2.5 nm, greater than or equal to about 3 nm, or greater than or equal to about 3.5 nm and less than or equal to about 10 nm, less than or equal to about 9 nm, less than or equal to about 8 nm, less than or equal to about 7 nm, less than or equal to about 6 nm, less than or equal to about 5 nm, or less than or equal to about 4.5 nm. A size of metal oxide nanoparticle can be a diameter or an equivalent diameter. The equivalent diameter is the value obtained by converting the size of a non-spherical particle into the diameter of a spherical particle. The size of the nanoparticles can be measured by appropriate means such as electron microscopy analysis like TEM or XRD. In this specification, the size can refer to the size of individual particles or the average size of a particle group.

In an embodiment, the metal oxide nanoparticle (e.g., the zinc oxide nanoparticle) may be prepared in any proper method, which is not particularly limited. The preparation of the metal oxide nanoparticles may include a solgel reaction. In an embodiment, the zinc oxide (e.g., zinc magnesium oxide) nanoparticle may be prepared by placing a zinc compound (e.g., an organic zinc compound such as zinc acetate dihydrate) and optionally an additional metal compound (e.g., an additional organic metal compound such as magnesium acetate tetrahydrate) in an organic solvent (e.g., dimethylsulfoxide) in a flask to have a desired mole ratio and heating the same at a predetermined temperature (e.g., from about 40 °C to about 120 °C, or from about 60 °C to about 100 °C) (e.g., in air), and adding a precipitation accelerator solution (for example, a solution of tetramethyl ammonium hydroxide pentahydrate and ethanol) at a predetermined rate with, e.g., while, stirring. The prepared zinc oxide nanoparticle (e.g., ZnₓMg₁₋ₓO nanoparticle) may be recovered from a reaction solution, for example via centrifugation.

In an embodiment, the electron auxiliary layer or the electron transport layer may be prepared in a solution process. In an embodiment, the electron auxiliary layer or the electron transport layer may be prepared by dispersing a plurality of metal oxide nanoparticles in an organic solvent (for example, a polar solvent, a non-polar solvent, or a combination thereof) to obtain an electron transport layer precursor dispersion, which is then applied to a surface to form a film. The electron transport layer precursor dispersion may be applied to the light emitting layer. The solution process may further include removing the organic solvent from the formed film, for example by evaporation. The organic solvent may include a C1 to C10 alcohol solvent or a combination thereof.

In an embodiment, a thickness of the electron transport layer (ETL) may be greater than or equal to about 3 nm, greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, greater than or equal to about 20 nm, greater than or equal to about 21 nm, greater than or equal to about 22 nm, greater than or equal to about 23 nm, greater than or equal to about 24 nm, greater than or equal to about 25 nm, greater than or equal to about 26 nm, greater than or equal to about 27 nm, greater than or equal to about 28 nm, greater than or equal to about 29 nm, greater than or equal to about 30 nm, greater than or equal to about 31 nm, greater than or equal to about 32 nm, greater than or equal to about 33 nm, greater than or equal to about 34 nm, or greater than or equal to about 35 nm. The thickness of the electron transport layer may be less than or equal to about 90 nm, less than or equal to about 80 nm, less than or equal to about 70 nm, less than or equal to about 60 nm, less than or equal to about 50 nm, less than or equal to about 45 nm, less than or equal to about 40 nm, or less than or equal to about 35 nm.

The thickness of the electron injection layer, the hole blocking layer, or a combination thereof is not particularly limited and may be appropriately selected. A thickness of the electron injection layer, the hole blocking layer, or a combination thereof may be greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, greater than or equal to about 20 nm, or greater than or equal to about 21 nm and less than or equal to about 120 nm, less than or equal to about 110 nm, less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 30 nm, or less than or equal to about 25 nm, but is not limited thereto.

In an embodiment, a material for the electron injection layer, the hole blocking layer, or a combination thereof may include 1,4,5,8-naphthalenetetracarboxylic dianhydride (NTCDA), bathocuproine (BCP), tris[3-(3-pyridyl)-mesityl]borane (3TPYMB), LiF, tris(8-hydroxyquinolinato)aluminum (Alq₃), tris(8-hydroxyquinolinato)gallium (Gaqs), tris(8-hydroxyquinolinato)indium (Inq₃), bis-(8-hydroxyquinolinato)zinc (Znq₂), bis[2-(2-hydroxyphenyl)benzothiazolato]zinc (Zn(BTZ)₂), bis(10-hydroxybenzo[H]quinolinato)beryllium (BeBq₂), 8-(4-(4,6-di(naphthalen-2-yl)-1,3,5-triazin-2-yl)phenyl)quinolone (ET204), 8-hydroxyquinolinato lithium (Liq), 2,2',2"-(1,3,5-Benzinetriyl)-tris(1-phenyl-1-H-benzimidazole) (TPBi), an n-type metal oxide (e.g., ZnO, HfO₂, etc.), 8-(4-(4,6-di(naphthalen-2-yl)-1,3,5-triazin-2-yl)phenyl)quinolone:8-hydroxyquinolinato lithium (ET204:Liq), or a combination thereof, but is not limited thereto.

In the light emitting device of an embodiment, the metal oxide nanoparticle included in the electron transport layer may provide higher electron mobility than an organic semiconductor material, and the light emitting layer, for example, being combined with the electron transport layer including the metal oxide nanoparticle, may exhibit a desired level of an electroluminescent property. In addition, the semiconductor nanoparticle-based emission layer may be formed by a solution process, and the metal oxide nanoparticle-based electron transport layer may be formed on the emission layer by a solution process, thereby being advantageous in the process.

However, the inventors have found that the combination of an electron auxiliary layer including metal oxide nanoparticles and a light emitting layer including semiconductor nanoparticles may not provide desired improvements both in electroluminescence properties and lifespan characteristics at the same time. For example, a metal oxide nanoparticle (e.g., a zinc magnesium oxide nanoparticle) may be grown through a sol-gel reaction involving a precursor (e.g., Zn(CH₃COO)₂, Mg(CH₃COO)₂) in the presence of a base. Various surface chemical species such as metal ions, for example, (Zn²⁺, Mg²⁺), O²⁻,-OH, CH₃COO⁻, may exist on a surface of a metal oxide nanoparticle as a result of the synthesis, and these surface chemical species may be a source of surface defects for the nanoparticle, acting as a defect level in the ETL. The surface defect present on the metal oxide (e.g., ZnMgO) particle may have an energy level near the HOMO level of the quantum dot or the semiconductor nanoparticle, and therefore, may serve as a trap site for holes and may cause an increase in leakage current.

It is believed that the metal oxide nanoparticle in the electron auxiliary layer or the electron transport layer may include various defects occurring in its manufacturing process and the film formation process, and these defects may provide various energy levels within the nanoparticles to be used as a passage for a hole movement, and therefore, a metal oxide nanoparticle-based electron transport layer may exhibit a reduced hole blocking performance or relatively high hole leakage current, which may adversely affect the electroluminescence property (e.g., a luminous efficiency) of the device.

In addition, the surface defect possibly present in the metal oxide nanoparticle may cause a lot of charge accumulation at an interface between the electron transport layer and the light emitting layer or in the electron transport layer, leading to a luminance decrease or a shortened lifespan of the light emitting device including a semiconductor nanoparticle.

In the light emitting device of an embodiment or a method of manufacturing the same, an electron transport layer including a metal oxide nanoparticle can be post-treated in the manner described herein by using an acid material (in a form of a film or in a form of a solution) and a thin film conductor. The light emitting device of an embodiment including the post-treated electron transport layer can exhibit an improved electroluminescence property and an enhanced life characteristic. In the post-treatment using the acid material (film) and a thin film conductor, the moisture and the acid component can easily diffuse into the electron transport layer in a remote manner, and thus it can be readily used in both a bottom emission type and a front emission type device.

In the post-treatment of an embodiment using the acid material and the thin film conductor, the acid and the moisture can be diffused remotely and induce a modification (e.g., surface modification) of a metal oxide nanoparticle contained in the electron transport layer, and thereby effectively reducing hole leakage current and solving charge accumulation and charging problems.

The acid component and moisture remotely diffused during post-treatment can induce the surface chemical reaction of the metal oxide nanoparticle in the electron transport layer, providing passivation of defects on the metal oxide nanoparticle surface, and increasing the conductivity of metal oxide nanoparticle. Therefore, the light emitting device of an embodiment can exhibit an extended lifespan together with improved efficiency.

In an embodiment, the acid material may be disposed near or on a stack structure including a first electrode, a light emitting layer, an electron transport layer, and a thin film conductor, for example, as being spaced apart from the thin film conductor and the electron transport layer or being remotely disposed (disposed remote) to release the acid and the moisture under the post-treatment conditions described herein. The released acid and the released moisture may be, for example evenly, diffused through a thin film conductor having a predetermined thickness to reach a metal oxide (e.g., ZnMgO) nanoparticles in the electron transport layer. In the method of an embodiment, the acid material may be provided in a form of a solution. In the method of an embodiment or the device of an embodiment, the acid material may be provided in the form of a layer (e.g., a film). The light emitting device of an embodiment may further include a container or a light-transmitting member configured to receive or accommodate at least a portion of the stacked structure, and the acid material may be disposed on a surface of the container (refer to FIGS. 1A, 1B, and 1C). A surface of the acid material (film) may be disposed to face the thin film conductor (e.g., to face a main surface of the thin film conductor). The acid material (film) may be disposed to face the electron transport layer (e.g., to face a main surface of the electron transport layer).

The hydrogen ion and the moisture supplied from the acid material of an embodiment can passivate a defect on a surface of the metal oxide nanoparticle, for example via a chemical reaction therebetween, to remove a trap site, thereby suppressing a leakage current of holes generated through the trap site of the metal oxide (e.g., ZnMgO) nanoparticle, and enhancing a hole blocking ability of the metal oxide-based electron transport layer. The light emitting device of an embodiment can show an increased external quantum efficiency (EQE) because the post-treatment may result in a more efficient hole-electron combination than conventional technology.

In addition, the post-treatment may provide the surface modification of the metal oxide nanoparticle, whereby reducing the trap site, and the charge accumulation at the trap site or the unwanted charging in the device can be prevented or suppressed. In addition, when being driven at the desired voltage for a long time, the device of an embodiment may exhibit a reduced/suppressed deterioration of the semiconductor nanoparticle or the ETL material (e.g., the metal oxide nanoparticle), and thus may exhibit an improved (e.g., extended) device lifespan.

In an embodiment, the acid material may include a polymeric acid compound, and the polymeric acid compound may include, for example, in a repeating unit thereof, a carboxyl group (COOH), a phosphonic acid group (PO(OH)₂), a sulfonic acid group (SOsH), or a combination thereof. In an embodiment, the acid material may be a non-polymeric acid compound including an inorganic acid such as sulfuric acid, hydrochloric acid, or the like; a C2-50 carboxylic acid compound (for example, represented by R(COOH)n); a sulfinic acid compound (for example, represented by R(SO₂H)n); a sulfonic acid compound (for example, represented by R(SO₃H)n), or a combination thereof. In an embodiment, the acid material may include, for example, a non-polymeric carboxylic acid compound represented by R(COOH)n. In the above formulas, R is a C1 to C50 or C3-C25 or C5-C8 substituted or unsubstituted aliphatic or aromatic hydrocarbon group, and n is 1 to 10 or 2 to 8 or 3 to 6, 4 to 5. The acid material may include both the polymeric acid compound and the non-polymeric acid compound (e.g., the non-polymeric carboxylic acid compound).

In an embodiment, the acid material (e.g., the polymeric acid compound or the non-polymeric carboxylic acid compound) may have a molecular weight or an average molecular weight (hereinafter, referred to as "molecular weight") that is greater than or equal to about 50 g/mol, greater than or equal to about 80 g/mol, greater than or equal to about 100 g/mol, greater than or equal to about 150 g/mol, greater than or equal to about 200 g/mol, greater than or equal to about 250 g/mol, greater than or equal to about 300 g/mol, greater than or equal to about 350 g/mol, greater than or equal to about 400 g/mol, greater than or equal to about 450 g/mol, greater than or equal to about 500 g/mol, greater than or equal to about 550 g/mol, greater than or equal to about 600 g/mol, greater than or equal to about 650 g/mol, greater than or equal to about 700 g/mol, greater than or equal to about 750 g/mol, greater than or equal to about greater than or equal to about 800 g/mol, greater than or equal to about 900 g/mol, greater than or equal to about 1000 g/mol, greater than or equal to about 1100 g/mol, greater than or equal to about 1200 g/mol, greater than or equal to about 1300 g/mol, greater than or equal to about 1400 g/mol, greater than or equal to about 1500 g/mol, greater than or equal to about 1600 g/mol, greater than or equal to about 1700 g/mol, greater than or equal to about 1800 g/mol, greater than or equal to about 1900 g/mol, greater than or equal to about 2000 g/mol, greater than or equal to about 2100 g/mol, greater than or equal to about 2200 g/mol, greater than or equal to about 2300 g/mol, greater than or equal to about 2400 g/mol, greater than or equal to about 2500 g/mol, greater than or equal to about 3000 g/mol, greater than or equal to about 3500 g/mol, greater than or equal to about 4000 g/mol, greater than or equal to about 4500 g/mol, greater than or equal to about 5000 g/mol, greater than or equal to about 5500 g/mol, greater than or equal to about 6000 g/mol, greater than or equal to about 7000 g/mol, greater than or equal to about 8000 g/mol, greater than or equal to about 9000 g/mol, greater than or equal to about 10000 g/mol, greater than or equal to about 15000 g/mol, greater than or equal to about 20000 g/mol, greater than or equal to about 25000 g/mol, greater than or equal to about 30000 g/mol, greater than or equal to about 35000 g/mol, greater than or equal to about 40000 g/mol, greater than or equal to about 45000 g/mol, greater than or equal to about 50000 g/mol, greater than or equal to about 55000 g/mol, greater than or equal to about 60000 g/mol, greater than or equal to about 65000 g/mol, greater than or equal to about 70000 g/mol, greater than or equal to about 75000 g/mol, greater than or equal to about 80000 g/mol, greater than or equal to about 85000 g/mol, greater than or equal to about 90000 g/mol, greater than or equal to about 95000 g/mol, greater than or equal to about 100000 g/mol, greater than or equal to about 120000 g/mol, greater than or equal to about 140000 g/mol, greater than or equal to about 160000 g/mol, greater than or equal to about 180000 g/mol, greater than or equal to about 200000 g/mol, greater than or equal to about 220000 g/mol, greater than or equal to about 240000 g/mol, greater than or equal to about 260000 g/mol, greater than or equal to about 280000 g/mol, greater than or equal to about 300000 g/mol, greater than or equal to about 350000 g/mol, greater than or equal to about 400000 g/mol, greater than or equal to about 450000 g/mol, greater than or equal to about 500000 g/mol, greater than or equal to about 550000 g/mol, or a combination thereof.

The molecular weight of the acid material may be less than or equal to about 8000000 g/mol, less than or equal to about 7000000 g/mol, less than or equal to about 6000000 g/mol, less than or equal to about 5000000 g/mol, less than or equal to about 4000000 g/mol, less than or equal to about 3000000 g/mol, less than or equal to about 2000000 g/mol, less than or equal to about 1500000 g/mol, less than or equal to about 1200000 g/mol, less than or equal to about 1000000 g/mol, less than or equal to about 900000 g/mol, less than or equal to about 800000 g/mol, less than or equal to about 700000 g/mol, less than or equal to about 600000 g/mol, less than or equal to about 500000 g/mol, less than or equal to about 450000 g/mol, less than or equal to about 200,000 g/mol, less than or equal to about 150,000 g/mol, less than or equal to about 100,000 g/mol, less than or equal to about 90,000 g/mol, less than or equal to about 80,000 g/mol, less than or equal to about 70,000 g/mol, less than or equal to about 50,000 g/mol, less than or equal to about 20,000 g/mol, less than or equal to about 10,000 g/mol, less than or equal to about 5000 g/mol, less than or equal to about 3000 g/mol, less than or equal to about 2000 g/mol, less than or equal to about 1000 g/mol, less than or equal to about 800 g/mol, less than or equal to about 500 g/mol, less than or equal to about 450 g/mol, less than or equal to about 400 g/mol, less than or equal to about 350 g/mol, less than or equal to about 300 g/mol, less than or equal to about 250 g/mol, less than or equal to about 200 g/mol, or a combination thereof.

In case where the acid material is the polymeric acid compound, the molecular weight (i.e., an average molecular weight) of the polymeric acid compound may be obtained taking into consideration a molecular weight (e.g., g/mol) of a monomer and a degree of polymerization of the repeating unit and may exhibit a molecular weight distribution. The average molecular weight of the polymeric acid compound may be an average molecular weight of the polymer, and may be a number average molecular weight, a weight average molecular weight, or a viscosity average molecular weight.

In an embodiment, the average molecular weight of the polymeric acid compound may be measured by using a solution of the polymeric acid compound. In order to reduce interactions between molecules of the polymer, the molecular weight may be measured by a dilute solution. The concentration of the polymer solution may be appropriately selected, and may be measured using, for example, a solution in which 1 gram or less of a polymer is dissolved per 100 milliliters (mL). The average molecular weight of the polymer may be measured by an appropriate method, such as a gel permeation chromatography, an end group analysis, an osmotic pressure method, a capillary viscosity method, or the like. In a gel permeation chromatography method, a polymer dissolved in a solvent may be separated in accordance with its size and an obtained result can be calibrated using a standard material with a determined molecular weight. In the terminal group analysis method, the molecular weight may be measured by quantifying a carboxyl group by dissolving a polymer in a solvent. Each measurement method may easily and reproducibly provide substantially the same information on molecular weight using commercially available devices according to established standards. The number average molecular weight, the weight average molecular weight, and the viscosity average molecular weight of the polymer may be related to each other.

The acid material (e.g., the polymeric acid compound, the non-polymeric carboxylic acid compound, or a combination thereof) may be commercially available from various manufacturers. The manufacturers provide information about the acid material (e.g., in case of the polymeric acid compound, a number average molecular weight, a weight average molecular weight, or the like), and thus the polymeric acid compound having a desired level and type of a molecular weight value may be commercially obtained.

The acid material (e.g., a polymeric acid compound, a non-polymeric carboxylic acid compound, or a combination thereof) may be water soluble and/or alcohol soluble. In an embodiment, the acid material (e.g., a polymeric acid compound, a non-polymeric carboxylic acid compound, or a combination thereof) may have a solubility in water or C1 to C10 alcohol, such as ethanol (e.g., at room temperature or at a temperature of 20°C or at 25°C) of greater than or equal to about 1 g/L, greater than or equal to about 10 g/L, greater than or equal to about 20 g/L, greater than or equal to about 30 g/L, greater than or equal to about 40 g/L, greater than or equal to about 50 g/L, greater than or equal to about 60 g/L, greater than or equal to about 70 g/L, greater than or equal to about 80 g/L, greater than or equal to about 90 g/L, greater than or equal to about 100 g/L, greater than or equal to about 110 g/L, greater than or equal to about 120 g/L, greater than or equal to about 130 g/L, greater than or equal to about 140 g/L, greater than or equal to about 150 g/L, greater than or equal to about 160 g/L, greater than or equal to about 170 g/L, greater than or equal to about 180 g/L, greater than or equal to about 190 g/L, greater than or equal to about 200 g/L, greater than or equal to about 210 g/L, greater than or equal to about 220 g/L, greater than or equal to about 230 g/L, greater than or equal to about 240 g/L, greater than or equal to about 250 g/L, greater than or equal to about 260 g/L, greater than or equal to about 270 g/L, greater than or equal to about 280 g/L, greater than or equal to about 290 g/L, greater than or equal to about 300 g/L, or a combination thereof, but is not limited thereto. In an embodiment, the solubility in water or C1 to C10 alcohol, such as ethanol (e.g., at room temperature or at a temperature of 20°C or at 25°C) of the acid material may be less than or equal to about 5000 g/L, less than or equal to about 4000 g/L, less than or equal to about 3000 g/L, less than or equal to about 1000 g/L, less than or equal to about 900 g/L, less than or equal to about 800 g/L, less than or equal to about 700 g/L, less than or equal to about 600 g/L, less than or equal to about 500 g/L, less than or equal to about 400 g/L, less than or equal to about 300 g/L, less than or equal to about 200 g/L, or a combination thereof, but is not limited thereto.

In an embodiment, the acid material may have a relatively high level of solubility with respect to water or a water miscible organic solvent e.g., an alcohol solvent, and a viscosity of a composition or a coating solution for forming the organic layer may be relatively readily controlled to form a layer or a film. Therefore, a higher degree of flexibility to form a film or a layer may be realized in comparison with an adhesive composition with a relatively high viscosity (e.g., a curable resin-based composition).

In an embodiment, the acid material may be configured to exhibit, in an aqueous or alcoholic solution state, a pH of less than or equal to about 5, less than or equal to about 4.9, less than or equal to about 4.7, less than or equal to about 4.4, less than or equal to about 4.2, less than or equal to about 4, less than or equal to about 3.8, less than or equal to about 3.6, less than or equal to about 3.4, less than or equal to about 3.2, less than or equal to about 3, less than or equal to about 2.8, less than or equal to about 2.6, less than or equal to about 2.4, less than or equal to about 2, less than or equal to about 1.8, less than or equal to about 1.7, less than or equal to about 1.6, less than or equal to about 1.55, less than or equal to about 1.5, or less than or equal to about 1. In an embodiment, the acid material may be configured to exhibit, in an aqueous or alcoholic solution state, a pH of greater than or equal to about 0.5, greater than or equal to about 1, greater than or equal to about 1.5, greater than or equal to about 1.8, greater than or equal to about 2, greater than or equal to about 2.5, greater than or equal to about 3, greater than or equal to about 3.5, greater than or equal to about 4, greater than or equal to about 4.5, or greater than or equal to about 4.8. In the aqueous or alcoholic solution of the acid material, a concentration of the polymeric acid compound may be from about 5 wt% to about 80 wt%, from about 10 wt% to about 75 wt%, from about 15 wt% to about 70wt%, from about 18 wt% to about 65 wt%, from about 20 wt% to about 60 wt%, from about 25 wt% to about 55 wt%, from about 30 wt% to about 50 wt%, or a combination thereof.

In an embodiment, the acid material may include a polymeric acid compound. The polymeric acid compound may include a polyacrylic acid, a polymethacrylic acid, a polyacrylic acid-methacrylic acid, a polyacrylic acid (partial or full) alkali metal salt, a copolymer including a (meth)acrylic acid repeating unit, a polyvinyl phosphonic acid compound, a poly(aromatic sulfonic acid), a poly(vinyl sulfonic acid) compound, a polymaleic acid, or a combination thereof (e.g., a copolymer or mixture thereof). The polymeric acid compound may further include an ester of the corresponding acid group (i.e., -COOR, R is an alkyl group or an aryl group). The poly(aromatic sulfonic acid) may include a polystyrene sulfonic acid, a polystyrene sulfonic acid-co-maleic acid, an alkali metal salt thereof, or a combination thereof.

In the embodiment, the acid material may include a non-polymeric carboxylic acid compound. The non-polymeric carboxylic acid compound may include a compound represented by R(COOH)n, wherein R is a substituted or unsubstituted C1 to C50 (C2-C10, C3-C6, C4-C5) aliphatic or aromatic hydrocarbon group, for example, a substituted or unsubstituted alkyl or alkylene group, a substituted or unsubstituted alkenyl or alkenylene group, a substituted or unsubstituted alkynyl or alkynylene group, or a substituted or unsubstituted aryl or arylene group, and the n is an integer of 1 to 10, 2 to 8, or 3 to 6.

The non-polymeric carboxylic acid compound may include a polycarboxylic acid compound having two or more carboxylic acid groups. The polycarboxylic acid compound may be a compound having 2 to 10, 3 to 7, 4 to 6, or 5 to 8 carboxylic acid groups. The polycarboxylic acid compound may have 1 to 10, 2 to 5, 3 to 4, substituted or unsubstituted, C₁₋₁₀₀, C₂₋₅₀, C₆₋₁₅, C₃₋₅ aliphatic hydrocarbon group(s), 1 to 10, 2 to 5, 3 to 4, substituted or unsubstituted, C₆₋₁₅ aromatic hydrocarbon group(s), or a combination thereof. The polycarboxylic acid compound may further include a hydroxyl group.

The non-polymeric carboxylic acid compound (e.g., the polycarboxylic acid compound) may include a compound represented by HOOC-A-(COOH)ₘ, wherein A is a single bond, a carbon atom, a substituted or unsubstituted C1 to C100 (C1-C50, C2-C45, C3-C40, C4-C20, C5-C15, C6-C12) aliphatic hydrocarbon group, such as alkylene, alkenylene, or alkynylene, a substituted or unsubstituted C6 to C40 aromatic hydrocarbon group, or a combination thereof, m is greater than or equal to about 1, greater than or equal to about 2, greater than or equal to about 3, or greater than or equal to about 4, and less than or equal to about 10, less than or equal to about 8, less than or equal to about 6, less than or equal to about 3. In the group A, at least one methylene may be replaced with CO, NH, O, COO, CONH, or a combination thereof. The group A may further have a hydroxyl group. The non-polymeric carboxylic acid compound or the polycarboxylic acid compound may have a carbon number of greater than or equal to about 2, greater than or equal to about 3, greater than or equal to about 4, greater than or equal to about 5, greater than or equal to about 6, greater than or equal to about 7, or greater than or equal to about 8. The non-polymeric carboxylic acid compound or the polycarboxylic acid compound may have a carbon number of less than or equal to about 100, less than or equal to about 60, less than or equal to about 15, less than or equal to about 14, less than or equal to about 13, less than or equal to about 12, less than or equal to about 11, less than or equal to about 10, less than or equal to about 9, less than or equal to about 8, less than or equal to about 7, less than or equal to about 6, or less than or equal to about 5. The non-polymeric carboxylic acid compound or the polycarboxylic acid compound may include a benzoic acid, a succinic acid, a maleic acid, a fumaric acid, a malic acid, a glutaric acid, an adipic acid, a pimelic acid, a citric acid, an oxalic acid, a malonic acid, a phthalic acid, an isophthalic acid, a terephthalic acid, a trimellitic acid, a hemimellitic acid, an azelaic acid, a suberic acid, a tartaric acid, an itaconic acid, a dodecanedioic acid, an acetic acid, a (meth)acrylic acid, or a combination thereof.

The acid material may include the polymeric acid compound and the non-polymeric carboxylic acid compound.

The acid material may further include or may not include an additive. The additive may include an inorganic acid such as a hydrochloric acid, a phosphoric acid, a carbonic acid, or a sulfuric acid; a sulfinic acid compound (e.g., represented by R(SO₂H)ₙ); a sulfonic acid compound (e.g., represented by R(SO₃H)ₙ); or a combination thereof. In the formulae, R may be a substituted or unsubstituted C1 to C50 aliphatic or aromatic hydrocarbon group, for example, a substituted or unsubstituted alkyl group, a substituted or unsubstituted alkenyl group, a substituted or unsubstituted alkynyl group, or a substituted or unsubstituted aryl group, and n is an integer of 1 to 10, 2 to 8, or 3 to 6. The sulfinic acid compound, the sulfonic acid compound, or a combination thereof may further include a hydroxyl group.

In the acid material (film), an amount of a crosslink type polymer (e.g., a crosslinked poly(meth)acrylate, a crosslinked epoxy, a crosslinked polysiloxane, a crosslinked urethane polymer, a crosslinked thiolene polymer, etc.) may be less than or equal to about 5 wt%, less than or equal to about 3 wt%, less than or equal to about 1 wt%, less than or equal to about 0.9 wt%, less than or equal to about 0.8 wt%, less than or equal to about 0.7 wt%, less than or equal to about 0.6 wt%, less than or equal to about 0.5 wt%, less than or equal to about 0.4 wt%, less than or equal to about 0.3 wt%, less than or equal to about 0.2 wt%, or less than or equal to about 0.1 wt%, based on a total weight of the organic layer. The acid material (film) may not substantially include the crosslinked polymer.

The acid material (film) may be configured to be dissolve at least a portion thereof as being immersed in water (or a C1 to C5 alcohol). The temperature of the water (or the temperature of the C1 to C5 alcohol) may be greater than or equal to about 25 °C. The temperature of the water (or the temperature of the C1 to C5 alcohol) may be less than or equal to a boiling point thereof (for example, less than or equal to about 50°C, or less than or equal to about 30°C).

In an embodiment, the acid material may have a form of a film, and the acid material (or a film thereof) may have a thickness of the organic layer may be greater than or equal to about 10 nm, greater than or equal to about 30 nm, greater than or equal to about 50 nm, greater than or equal to about 70 nm, greater than or equal to about 90 nm, greater than or equal to about 100 nm, greater than or equal to about 120 nm, greater than or equal to about 140 nm, greater than or equal to about 160 nm, greater than or equal to about 180 nm, greater than or equal to about 200 nm, greater than or equal to about 250 nm, greater than or equal to about 300 nm, greater than or equal to about 350 nm, greater than or equal to about 400 nm, greater than or equal to about 450 nm, greater than or equal to about 500 nm, greater than or equal to about 550 nm, greater than or equal to about 600 nm, greater than or equal to about 650 nm, greater than or equal to about 700 nm, greater than or equal to about 750 nm, greater than or equal to about 800 nm, greater than or equal to about 850 nm, greater than or equal to about 900 nm, greater than or equal to about 950 nm, greater than or equal to about 1 micrometer (µm), or greater than or equal to about 1.5 µm.

The thickness of the acid material may be less than or equal to about 100 µm, less than or equal to about 90 µm, less than or equal to about 80 µm, less than or equal to about 70 µm, less than or equal to about 60 µm, less than or equal to about 50 µm, less than or equal to about 40 µm, less than or equal to about 30 µm, less than or equal to about 20 µm, less than or equal to about 10 µm, less than or equal to about 9 µm, less than or equal to about 8 µm, less than or equal to about 7 µm, less than or equal to about 6 µm, less than or equal to about 5 µm, less than or equal to about 4 µm, less than or equal to about 3 µm, less than or equal to about 2 µm, or less than or equal to about 1 µm. The thickness of the acid material may be greater than or equal to about 10 nm, greater than or equal to about 100 nm, greater than or equal to about 500 nm, greater than or equal to about 1 µm, or greater than or equal to about 1.5 µm.

In an embodiment, the light-emitting device may further include a container configured to accommodate at least a portion of a stacked structure including a first electrode, a light-emitting layer, an electron transport layer, and a thin film conductor (or a second electrode). The container may include a light transmitting member (for example, a light transmitting material or a light transmitting component). The container may further include an additional member bonded or linked to the light transmitting member and the additional member may include a light transmitting or a non-light transmitting material, a sealing material). In an embodiment, the container may be a one body material. In an embodiment, the container may be formed by combining multiple components. In an embodiment, the container may be a one-body type light transmitting component or member (e.g., an encapsulation glass) (see: FIG. 1B and FIG. 7 encapsulation glass). In an embodiment, the container may include a light transmitting member (e.g., light transmitting component) and a seal. The container may be an encapsulation element for the laminated structure. The container or the light-transmitting member may include an organic material such as a polymer, an inorganic material such as glass, an organic and inorganic hybrid material, or a combination thereof. The container may be an oven or a chamber. Details of the container (e.g., a material, a transmittance, etc.) can be referred to the description made herein for the substrate. In an embodiment, the oven may be an equipment or an apparatus configured to expose a given material to a high temperature environment (e.g., a post treatment temperature described herein such as a temperature of 50°C or higher, 70°C or higher, 90°C or higher), and the heating manner is not particularly limited. The oven includes a hollow chamber, and includes a heating element configured to heat the chamber in a controlled manner. The hollow chamber may provide the defined space.

In the light emitting device of an embodiment, the acid material (film) may be disposed to be adjacent to or in contact with the container or the light-transmitting member (or component). The acid material (film) may be applied or coated on a surface of the container or the light-transmitting member. The light emitting device of an embodiment may not include the acid material (film).

In an embodiment, the light emitting device may further include a hole auxiliary layer 2, 20 between the first electrode 1, 10 and the light emitting layer 3, 30. The hole auxiliary layer 2, 20 may include a hole injection layer, a hole transport layer, an electron blocking layer, or a combination thereof. The hole auxiliary layer 2, 20 may be a single layer or a multilayer structure in which adjacent layers include different components. (Reference to FIGS. 1A, 1B, and 2)

The hole auxiliary layer 2, 20 may have a HOMO energy level that can be matched with the HOMO energy level of the light emitting layer 3, 30 in order to enhance mobility of holes transferred from the hole auxiliary layer 2, 20 to the light emitting layer 3, 30. In an embodiment, the hole auxiliary layer 2, 20 may include a hole injection layer close to, e.g., adjacent, the first electrode 1, 10 and a hole transport layer close to, e.g., adjacent, the light emitting layer 3, 30.

In an embodiment, the material included in the hole auxiliary layer 2, 20 (e.g., a hole transport layer, a hole injection layer, or an electron blocking layer) is not particularly limited, and may include, for example, poly(9,9-dioctyl-fluorene-co-N-(4)-butylphenyl)-diphenylamine) (TFB), polyarylamine, poly(N-vinylcarbazole), poly(3,4-ethylenedioxythiophene) (PEDOT), poly(3,4-ethylenedioxythiophene): polystyrene sulfonate (PEDOT:PSS), polyaniline, polypyrrole, N,N,N',N'-tetrakis(4-methoxyphenyl)-benzidine (TPD), 4,4'-bis[N-(1-naphthyl)-N-phenyl-amino]biphenyl (α-NPD), m-MTDATA (4,4',4"-Tris[phenyl(m-tolyl)amino]triphenylamine), 4,4',4"-tris(N-carbazolyl)-triphenylamine (TCTA), 1,1-bis[(di-4-toylamino)phenyl]cyclohexane (TAPC), a p-type metal oxide (e.g., NiO, WOs, MoOs, etc.), a carbon-based material such as graphene oxide, or a combination thereof, but is not limited thereto.

In the hole auxiliary layer, the thickness of each layer may be appropriately selected. For example, the thickness of each layer may be greater than or equal to about 5 nm, greater than or equal to about 10 nm, greater than or equal to about 15 nm, or greater than or equal to about 20 nm and less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 35 nm, or less than or equal to about 30 nm, but is not limited thereto.

In the device of an embodiment, the anode 1, 10 disposed on the transparent substrate 100 may include a metal oxide-based transparent electrode (e.g., an ITO electrode), and the cathode 5, 50 facing the anode 1, 10 may include a conductive metal (e.g., having a relatively low work function, Mg, Al, etc.). The hole auxiliary layer 2, 20 (e.g., a hole injection layer such as PEDOT:PSS, p-type metal oxide, or a combination thereof; a hole transport layer such as TFB, polyvinylcarbazole (PVK), or a combination thereof; or a combination thereof) may be provided between the transparent electrode 10 and the light emitting layer 30. The hole injection layer may be disposed close to, e.g., adjacent, the transparent electrode and the hole transport layer may be disposed close to, e.g., adjacent, the light emitting layer. The electron transport layer or the electron auxiliary layer including the same (such as an electron injection/transport layer) 40 may be disposed between the light emitting layer 30 and the cathode 50.

In an embodiment, the light emitting device may include an anode 1, 10 disposed on the substrate 100 and the driving circuit (e.g., TFT, not shown); hole auxiliary layers 2, 20 disposed on the anode above; light emitting layers 3, 30 disposed on the hole auxiliary layer; electron auxiliary layers (or electron transport layers) 4, 40 disposed on the light emitting layer; and cathode or thin film conductor 5, 50 disposed on the electron auxiliary layer. In an embodiment, the anode may be a reflective electrode, the cathode may be a transparent or translucent electrode, and the light emitting device may be a top emission type light emitting device. (see FIG. 4) In an embodiment, the anode may be a transparent electrode, the second electrode may be a reflective electrode, and the light emitting device may be a bottom emission type. (see FIG. 8)

In an embodiment, the light emitting device of an embodiment may be manufactured by a method, which includes:
forming a light emitting (e.g., a patterned) layer including a semiconductor nanoparticle on or over a first electrode, forming an electron transport layer on the light emitting layer, and forming a second electrode on or over the electron transport layer to form a stacked structure, and conducting a post-treatment for the stacked structure using an acid material and a container.

In an embodiment, the method may further include forming a hole auxiliary layer on the first electrode (for example, disposed on a substrate), for example via a physical deposition (e.g., a vapor deposition) or a coating process. The method may further include forming an electron injection layer and/or a hole blocking layer on or over the electron transport layer. The forming of the light emitting layer (or a patterned layer) of the semiconductor nanoparticles is the same as described herein.

In an embodiment, the post-treatment includes placing at least a portion of the stacked structure, for example, the electron transport layer and the second electrode, and the acid material together in a space (e.g., a closed space) defined by the container; and
keeping the stacked structure in the defined space at a post-treatment temperature of greater than or equal to about 40°C and less than or equal to about 200°C within the defined space; and wherein the acid material includes a polymeric acid, a non-polymeric acid compound (e.g., a non-polymeric carboxylic acid compound), or a combination thereof.

In an embodiment, the non-polymeric acid compound may include an inorganic acid such as sulfuric acid, hydrochloric acid, or the like; a carboxylic acid compound (for example, represented by R(COOH)n); a sulfinic acid compound (for example, represented by R(SO₂H)n); a sulfonic acid compound (for example, represented by R(SOsH)n), or a combination thereof. In an embodiment, the acid material may include, for example, a non-polymeric C2-C51 carboxylic acid compound for example represented by R(COOH)n. In the above formulas, R is a C1 to C50 or C3-C25 or C5-C8 substituted or unsubstituted aliphatic or aromatic hydrocarbon group, and n is 1 to 10 or 2 to 8 or 3 to 6, 4 to 5. The acid material may include both the polymeric acid compound and the non-polymeric acid compound (e.g., the non-polymeric carboxylic acid compound). Further details of the acid material, the polymeric acid compound and the non-polymeric acid compound are the same as described herein.

The space may be a closed space, for example, a sealed space or a hermitic or airtight space. The method may further include removing the container or separating the stacked structure from the container after the post-treatment. The post-treatment may be performed for a predetermined time.

The container may include a light-transmitting member (for example, a light transmitting material or component). The container may be or include an encapsulation glass configured to accommodate at least a portion (or the entire) of the stacked structure. The container may be a separate device or a separate apparatus that can control a temperature, such as an oven or a chamber, and provide a space (e.g., a closed space).

Details of the container and the post treatment are the same as described herein.

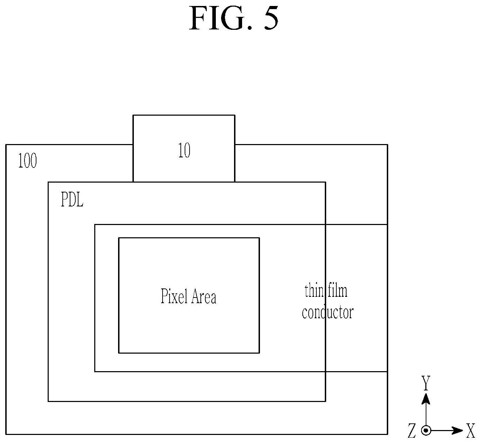

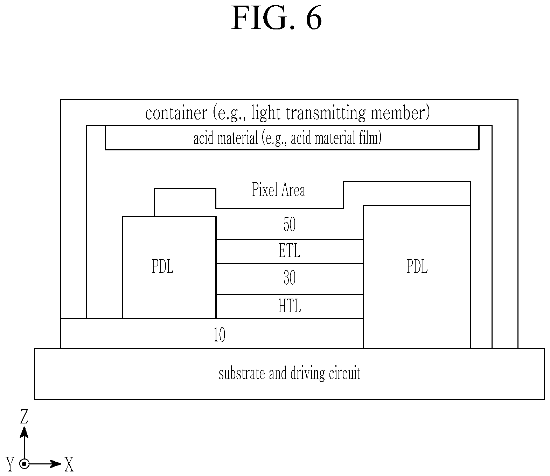

In the method of an embodiment, a stacked structure may be obtained by forming a light emitting layer and an electron transport layer on a first electrode and for example between the pixel defining layers (PDL) and then forming a thin film conductor on the electron transport layer (see FIGS. 4 and 5). The method may further include forming a hole auxiliary layer on the first electrode for example, prior to the formation of the light emitting layer. The acid material and the container may be provided to the stacked structure thus obtained so that the acid material and at least a portion of the stacked structure (for example, the electron transporting layer and the thin film conductor) can be placed in the space defined by the container. (see FIG. 6, FIG. 7, and FIG. 9)

Surprisingly, the present inventors have found that the properties of the light-emitting device can be significantly improved by conducting the post treatment described herein. The acid material can release an acid and a moisture under the post-processing conditions described herein, and the released acid and the released moisture may diffuse through the thin film conductor to modify a surface of the metal oxide particle in the electron transport layer, thereby improving the properties of the light-emitting device.

The thin film conductor may have a prescribed thickness so that it may have a conductivity capable of serving as an electron injection conductor and may allow the acid/moisture released from the acid material to be diffused or spread (for example downward) and to be transferred to the electron transport layer disposed under the thin film conductor. Providing an acid/moisture vapor environment and creating a relatively high-temperature environment can promote the surface modification reaction.

The method may further include preparing an acid material-containing composition comprising a liquid vehicle (e.g., a solvent) and the acid material. The details of the acid material are the same as described herein. The method may include providing the acid material-containing composition to the container or the space defined by the container. It may also include applying the acid material-containing composition to a surface of the container to form a film of the acid material. The acid material-containing composition may be obtained by dissolving the acid material and optionally the additive in a liquid vehicle. The details of the additive are the same as described above. The concentration of the additive may be appropriately selected taking into consideration the type of the additive, the type of the acid material, and the thickness of the acid material film to be formed.

The liquid vehicle may include an alcohol solvent such as ethanol, methanol, propanol, isopropanol, (iso)butanol, (iso)pentanol, hexanol, heptanol, octanol, nonanol, etc.; a nitrile solvent such as acetonitrile; an ester solvent such as ethyl acetate; or a combination thereof.

The acid material has a relatively high level of solubility in water or an organic solvent, and it may readily provide an acid material-containing composition with an appropriate viscosity. A viscosity of the acid material-containing composition may be, at room temperature (for example, a temperature of from about 20 °C to about 30 °C, or at 25 °C), from about 2 centipoise (cPs) to about 2000 cPs, from about 3 cPs to about 1500 cPs, from about 7 cPs to about 1200 cPs, from about 10 cPs to about 1000 cPs, from about 15 cPs to about 800 cPs, from about 20 cPs to about 700 cPs, from about 30 cPs to about 500 cPs, from about 40 cPs to about 150 cPs, from about 50 cPs to about 100 cPs, or a combination thereof, but is not limited thereto.

It may be appropriately selected in consideration of the concentration of the acid material, the type of the acid material, the type of the additive, and the desired thickness of the organic layer in the acid material-containing composition.

In an embodiment, a concentration of the acid material (e.g., the polymeric acid compound) in the acid material containing composition may be, based on a total weight of the composition, greater than or equal to about 0.01 wt%, greater than or equal to about 0.05 wt%, greater than or equal to about 0.1 wt%, greater than or equal to about 0.5 wt%, greater than or equal to about 1 wt%, greater than or equal to about 2 wt%, greater than or equal to about 3 wt%, greater than or equal to about 4 wt%, greater than or equal to about 5 wt%, greater than or equal to about 6 wt%, greater than or equal to about 7 wt%, greater than or equal to about 8 wt%, greater than or equal to about 9 wt%, greater than or equal to about 10 wt%, greater than or equal to about 11 wt%, greater than or equal to about 12 wt%, greater than or equal to about 13 wt%, greater than or equal to about 14 wt%, greater than or equal to about 15 wt%, greater than or equal to about 16 wt%, greater than or equal to about 17 wt%, greater than or equal to about 18 wt%, greater than or equal to about 19 wt%, greater than or equal to about 20 wt%, greater than or equal to about 11 wt%, greater than or equal to about 12 wt%, greater than or equal to about 13 wt%, greater than or equal to about 14 wt%, greater than or equal to about 15 wt%, greater than or equal to about 16 wt%, greater than or equal to about 17 wt%, greater than or equal to about 18 wt%, greater than or equal to about 19 wt%, greater than or equal to about 20 wt%, greater than or equal to about 21wt%, greater than or equal to about 22 wt%, greater than or equal to about 23 wt%, greater than or equal to about 24 wt%, greater than or equal to about 25 wt%, greater than or equal to about 26 wt%, greater than or equal to about 27 wt%, greater than or equal to about 28 wt%, greater than or equal to about 29 wt%, greater than or equal to about 30 wt%, greater than or equal to about 31 wt%, greater than or equal to about 32 wt%, greater than or equal to about 33 wt%, greater than or equal to about 34 wt%, greater than or equal to about 35 wt%, greater than or equal to about 36 wt%, greater than or equal to about 37 wt%, greater than or equal to about 38 wt%, greater than or equal to about 39 wt%, or greater than or equal to about 40 wt%. In an embodiment, a concentration of the acid material in the acid material containing composition may be, based on a total weight of the composition, less than or equal to about 99 wt%, less than or equal to about 90 wt%, less than or equal to about 85 wt%, less than or equal to about 80 wt%, less than or equal to about 75 wt%, less than or equal to about 70 wt%, less than or equal to about 65 wt%, less than or equal to about 60 wt%, less than or equal to about 55 wt%, less than or equal to about 50 wt%, less than or equal to about 45 wt%, less than or equal to about 40 wt%, less than or equal to about 35 wt%, less than or equal to about 30 wt%, less than or equal to about 25 wt%, less than or equal to about 20 wt%, less than or equal to about 15 wt%, less than or equal to about 10 wt%, or less than or equal to about 5 wt%.

If present, a concentration of the acid material (e.g., the non-polymeric acid compound) or the additive in the acid material containing composition may be from about 0.0001 mole/L (M) to about 10M, 0.0005M to about 5M, 0.001M to about 4M, 0.005M to about 3M, 0.01M to about 2M, 0.05M to about 1.5M, 0.1M to about 1.3M, 0.1M to about 1.2M, 0.15M to about 1M, 0.15M to about 0.9M, 0.2M to about 0.8M, 0.3M to about 0.7M, 0.4M to about 0.6M, 0.45M to about 0.55M, or a combination thereof.

The manner of applying the acid material containing composition is not particularly limited and may be selected appropriately. The application manner may include a spin coating, a blading, a drop cast, or a combination. After the application of the acid material containing composition, an excess amount of the composition may be removed by spinning or the like.

Formation of the acid material (film) may not involve a polymerization reaction and/or a crosslinking reaction. Therefore, the content of the crosslinked polymer in the acid material (film) may be less than 1% by weight. Remarkable light absorption may occur in a predetermined range of wavelengths when a layer containing a crosslinked polymer (e.g., as a major component) is disposed in the light extraction path, and such a light-emitting device including the crosslinked polymer cannot be used to, for example, a top emission type display panel wherein the second electrode is used as a transparent or light extracting electrode. Furthermore, the acid material (film) containing the crosslinked resin may have a relatively high viscosity, which may make it difficult to form the acid material (film) to have the desired thickness. Furthermore, the present inventors have found that the acid material containing the crosslinked resin as the main component does not provide sufficient acid and moisture in the method of an embodiment.

In an embodiment, the post-treatment may be carried out under an appropriate atmosphere (e.g., under an inert gas atmosphere or in an oxygen-free atmosphere or in the air).

As the acid material (e.g., having the molecular weight described herein) is a hydrophilic polymer or a hydrophilic compound, there may be relatively increased amount of moisture and relatively labile acid moieties (e.g., COOH groups) in the acid material (film). The acid material (film) of an embodiment can release moisture and acid relatively easily and gradually under a predetermined atmosphere (e.g., an inert gas atmosphere or atmospheric atmosphere) and a predetermined temperature. The released moisture and the released acid can diffuse through a thin film conductor having a prescribed thickness to reach a metal oxide nanoparticle present in the electron auxiliary layer and can achieve a surface modification thereof. In an embodiment, the moisture and the acid components that have moved relatively easily and gradually to the electron auxiliary layer can participate in an interaction or reaction (e.g., a dehydration condensation reaction, etc.) with a metal oxide nanoparticle (e.g., hydroxyl groups or various defect sites that may exist on the surface of the metal oxide nanoparticle). It is believed that these interactions and reactions can modify the surface of metal oxide nanoparticle to eliminate defects and/or can lead to the growth of nanoparticle.

The post-treatment temperature may be greater than or equal to about 40°C, greater than or equal to about 45°C, greater than or equal to about 50°C, greater than or equal to about 55°C, greater than or equal to about 60°C, greater than or equal to about 65°C, greater than or equal to about 70°C, or greater than or equal to about 75°C. The post-treatment temperature may be less than or equal to about 200°C, less than or equal to about 190°C, less than or equal to about 180°C, less than or equal to about 160°C, less than or equal to about 140°C, less than or equal to about 120°C, less than or equal to about 100°C, less than or equal to about 90°C, less than or equal to about 80°C, or less than or equal to about 70°C.

The post-treatment time (i.e., the predetermined time of the post treatment) may be greater than or equal to about 1 hour, greater than or equal to about 3 hours, greater than or equal to about 5 hours, greater than or equal to about 7 hours, greater than or equal to about 12 hours, greater than or equal to about 20 hours, greater than or equal to about 24 hours, greater than or equal to about 36 hours, greater than or equal to about 48 hours, or greater than or equal to about 50 hours and less than or equal to about 30 days, less than or equal to about 20 days, less than or equal to about 10 days, less than or equal to about 5 days, less than or equal to about 3 days, less than or equal to about 2 days, less than or equal to about 1 day, less than or equal to about 18 hours, less than or equal to about 14 hours, less than or equal to about 8 hours, less than or equal to about 7 hours, less than or equal to about 5 hours, less than or equal to about 4 hours, less than or equal to about 3 hours, less than or equal to about 2 hours, or less than or equal to about 1 hour.

The method of an embodiment may further include forming a thin film conductor (or a second electrode) having an increased thickness by further providing a conductive layer on the thin film conductor after the post-treatment. (see FIG. 8).

In an embodiment, a light emitting device includes a first electrode (e.g., a hole injection conductor or an anode) and a second electrode, a light emitting layer disposed between the first electrode and the second electrode; and an electron transport layer between the light emitting layer and the second electrode,
wherein the light emitting layer includes a semiconductor nanoparticle, and the light emitting layer is configured to emit a first light,
the electron transport layer includes a metal oxide nanoparticle, and the metal oxide nanoparticle has a size of greater than or equal to about 1 nm and less than or equal to about 30 nm or less, and the metal oxide nanoparticle includes zinc, and optionally a Group IIA metal, Zr, W, Li, Ti, Y, Al, gallium, indium, tin (Sn), cobalt (Co), vanadium (V), or a combination thereof,
wherein the second electrode have a thickness of greater than or equal to about 1 nm (or greater than 10 nm) and less than or equal to about 50 nm, and the second electrode has a light transmittance for the first light that is greater than or equal to about 50% and less than or equal to about 100%,
wherein the first electrode is configured to reflect at least a portion of the first light.

The first electrode may include a hole injection conductor, and the second electrode may include an electron injection conductor.

The semiconductor nanoparticle or the light emitting layer may not contain cadmium, lead, mercury, or a combination thereof.

The second electrode may have a thickness of greater than or equal to about 11 nm and less than or equal to about 40 nm.

The first electrode may be configured to reflect at least a portion of the first light.

The light-emitting device may be configured to emit green light when a voltage is applied. The light-emitting device may be configured to emit blue light when a voltage is applied. The light-emitting device may be configured to emit red light when a voltage is applied.

The light emitting device may further include a layer of an acid material disposed on the electron transport layer, and the acid material may include a polymeric acid compound, a non-polymeric carboxylic acid compound, or a combination thereof.

The layer (or the film) of the acid material may be disposed as being spaced apart from the electron transport layer and the second electrode. The layer of the acid material may be disposed to face the electron transport layer and/or the second electrode or the thin film conductor.

The electron transport layer may have a first surface facing the light emitting layer and a second surface opposite to the first surface, and the layer of the acid material may be disposed on the second surface. The layer of the acid material may be spaced apart from the electron transport layer (e.g., separated from the electron transport layer).

The layer (or the film) of the acid material may have a thickness of greater than or equal to about 10 nm, or greater than or equal to about 100 nm. The thickness of the acid material layer (or film) may be less than or equal to about 100 micrometers (um), or less than or equal to about 10 µm.

The thin film conductor or the second electrode may have a first surface facing a surface of the electron auxiliary layer and a second surface opposite to the first surface, and the acid material film may be disposed, spacing apart from the electron transport layer and/or the second electrode and may be disposed to face at least a portion (e.g., all) of the surface of the electron transport layer and/or at least a portion (e.g., all) of the second surface of the second electrode.

Details for the light emitting device (e.g., the elements thereof such as the semiconductor nanoparticle, the metal oxide nanoparticle, the first/second electrode, the thin film conductor, the acid material, and the acid material layer or film are the same as described herein. For the details of the second electrode, it is possible to refer to the description of the thin film conductor, as well.

The light emitting device of an embodiment may be configured to emit red light, green light, or blue light. Details (e.g., the wavelength) of red light, green light, or blue light are the same as described herein.

In an embodiment, the light emitting device may have a maximum external quantum efficiency (EQE) of greater than or equal to about 5%, greater than or equal to about 5.5%, greater than or equal to about 6%, greater than or equal to about 6.5%, greater than or equal to about 7%, greater than or equal to about 7.5%, greater than or equal to about 7.7%, greater than or equal to about 8%, greater than or equal to about 8.5%, greater than or equal to about 9%, greater than or equal to about 9.5%, greater than or equal to about 10%, greater than or equal to about 10.5%, greater than or equal to about 11%, greater than or equal to about 11.5%, greater than or equal to about 12%, greater than or equal to about 12.5%, greater than or equal to about 13%, greater than or equal to about 13.5%, or greater than or equal to about 14%. The maximum external quantum efficiency (EQE) may be less than or equal to about 60%, less than or equal to about 50%, less than or equal to about 40%, less than or equal to about 30%, or less than or equal to about 20%.

The light emitting device of an embodiment may exhibit a maximum luminance of greater than or equal to about 10,000 candela per square meter (cd/m²), greater than or equal to about 30,000 cd/m², greater than or equal to about 40,000 cd/m², greater than or equal to about 60,000 cd/m², greater than or equal to about 65,000 cd/m², greater than or equal to about 70,000 cd/m², greater than or equal to about 80,000 cd/m², greater than or equal to about 90,000 cd/m², greater than or equal to about 100,000 cd/m², greater than or equal to about 110,000 cd/m², or greater than or equal to about 120,000 cd/m².

The light emitting device of an embodiment may exhibit a maximum luminous efficiency of greater than or equal to about 5 candela per ampere (cd/A), greater than or equal to about 5.5 cd/A, greater than or equal to about 6 cd/A, greater than or equal to about 7 cd/A, greater than or equal to about 8 cd/A, greater than or equal to about 9 cd/A, greater than or equal to about 10 cd/A, greater than or equal to about 15 cd/A, greater than or equal to about 20 cd/A, or greater than or equal to about 30 cd/A. The light emitting device of an embodiment may exhibit a maximum luminous efficiency of less than or equal to about 1000 cd/A, less than or equal to about 500 cd/A, or less than or equal to about 100 cd/A.

In an embodiment, as measured by driving the device at a predetermined initial luminance (for example, about 650 nit), the light emitting device may exhibit a T50 of greater than or equal to about 20 hours, greater than or equal to about 25 hours, greater than or equal to about 30 hours, greater than or equal to about 40 hours, greater than or equal to about 50 hours, greater than or equal to about 60 hours, greater than or equal to about 65 hours, greater than or equal to about 70 hours, greater than or equal to about 80 hours, greater than or equal to about 90 hours, greater than or equal to about 100 hours, greater than or equal to about 120 hours, greater than or equal to about 150 hours, greater than or equal to about 180 hours, greater than or equal to about 200 hours, or greater than or equal to about 250 hours.

In an embodiment, as measured by driving the device at a predetermined initial luminance (for example, about 650 nit), the light emitting device may have a T90 of greater than or equal to about 5 hours, e.g., a T90 of greater than or equal to about 6 hours, greater than or equal to about 7 hours, greater than or equal to about 7.5 hours, greater than or equal to about 8 hours, greater than or equal to about 9 hours, greater than or equal to about 10 hours, greater than or equal to about 20 hours, greater than or equal to about 30 hours, greater than or equal to about 40 hours, greater than or equal to about 50 hours, greater than or equal to about 60 hours, greater than or equal to about 70 hours, greater than or equal to about 80 hours, greater than or equal to about 90 hours, greater than or equal to about 100 hours, greater than or equal to about 110 hours, greater than or equal to about 120 hours, or greater than or equal to about 130 hours. The T90 may be from about 35 hours to about 1500 hours, from about 55 hours to about 1200 hours, from about 85 hours to about 1000 hours, from about 105 hours to about 900 hours, from about 115 hours to about 800 hours, from about 145 hours to about 500 hours, or a combination thereof.

In an embodiment, a display device includes the light emitting device described herein.

The display device may include a first pixel and a second pixel that is configured to emit light different from the light of the first pixel.

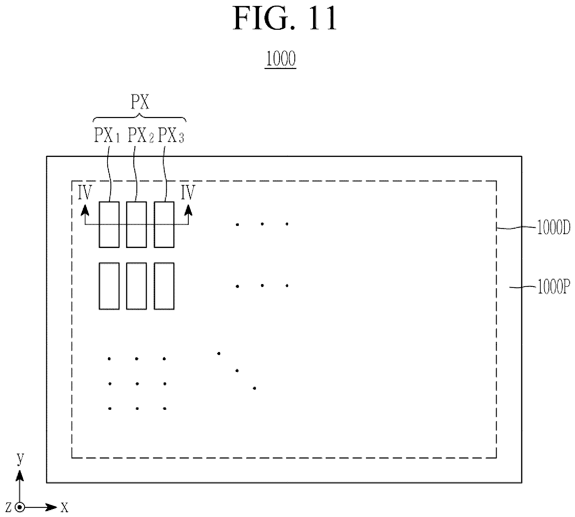

Referring to FIG. 11, a display panel 1000 according to an embodiment includes a display area 1000D for displaying an image and a non-display area 1000P disposed around the display area 1000D, in which the binding element may be located.

The display area 1000D may include a plurality of pixels PXs arranged along a row (e.g., x direction) and/or a column (e.g., y direction), and each pixel PX may include a plurality of sub-pixels PX₁, PX₂, and PX₃ displaying different colors. As an example, a configuration in which three sub-pixels PX₁, PX₂, and PX₃ constitute one pixel PX is illustrated, but the configuration is not limited thereto. An additional sub-pixel such as a white sub-pixel may be further included, and one or more sub-pixel displaying the same color may be included. The plurality of pixels PXs may be arranged in, for example, a Bayer matrix, a PenTile matrix, and/or a diamond matrix, but is not limited thereto.

Each of the sub-pixels PX₁, PX₂, and PX₃ may be configured to display a color of three primary colors or a combination of three primary colors, for example, red, green, blue, or a combination thereof (e.g., white light). For example, the first sub-pixel PX₁ may be configured to display red, the second sub-pixel PX₂ may be configured to display green, and the third sub-pixel PXs may be configured to display blue.

In FIG 11, each of the sub-pixels are depicted to have the same size, but the present disclosure is not limited thereto. For example, at least one of the sub-pixels may be larger or smaller, or have a different shape, than another sub-pixel.

In an embodiment, the display panel of an embodiment may include a light emitting panel which may include a lower substrate 110, a buffer layer 111, a thin film transistor TFT, and a light emitting element 180. The display panel may further include a circuit element for switching and/or driving each of the light emitting elements.

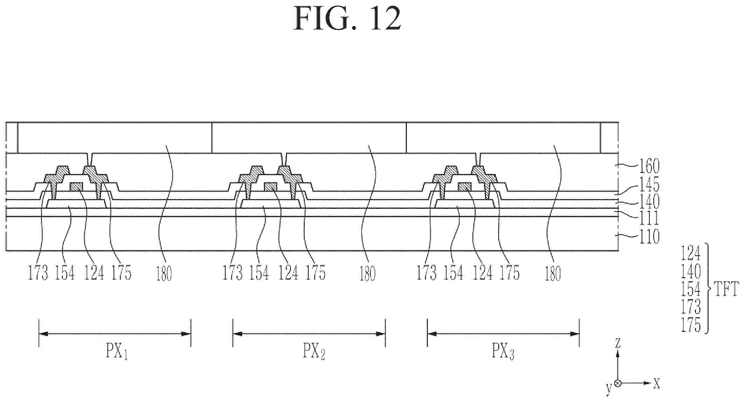

Referring to FIG. 12, in the light emitting panel of an embodiment, the light emitting element 180 may be disposed for each sub-pixel PX₁, PX₂, and PX₃. The light emitting element 180 disposed in each sub-pixel PX₁, PX₂, and PX₃ may be independently driven. The subpixel may include a blue subpixel, red subpixel, or a green subpixel. At least one of the light emitting element 180 may be an electroluminescent element according to an embodiment described herein.

Details of the substrate are the same as described herein. The buffer layer 111 may include an organic material, an inorganic material, or an organic-inorganic material. The buffer layer 111 may include, for example, an oxide, a nitride, or an oxynitride, and may include, for example, silicon oxide, silicon nitride, silicon oxynitride, or a combination thereof, but is not limited thereto. The buffer layer 111 may be one layer or two or more layers and may cover a portion of or the entire surface of the lower substrate 110. The buffer layer 111 may be omitted.

The thin film transistor TFT may be a three terminal element for switching and/or driving the light emitting element 180, and one or two or more may be included for each sub-pixel. The thin film transistor TFT may include a gate electrode 124, a semiconductor layer 154 overlapped with the gate electrode 124, a gate insulating layer 140 between the gate electrode 124 and the semiconductor layer 154, and a source electrode 173 and a drain electrode 175 electrically connected to the semiconductor layer 154. A coplanar top gate structure is shown as an example, but the structure is not limited thereto and may have various structures.

The gate electrode 124 is electrically connected to a gate line (not shown), and may include, for example, a low-resistance metal such as aluminum (Al), molybdenum (Mo), copper (Cu), titanium (Ti), silver (Ag), gold (Au), an alloy thereof, or a combination thereof, but is not limited thereto.

The semiconductor layer 154 may be an inorganic semiconductor such as amorphous silicon, polycrystalline silicon, or oxide semiconductor; an organic semiconductor; an organic-inorganic semiconductor; or a combination thereof. For example, the semiconductor layer 154 may include an oxide semiconductor including at least one of indium (In), zinc (Zn), tin (Sn), and gallium (Ga), and the oxide semiconductor may include, for example, indium-gallium-zinc oxide, zinc-tin oxide, or a combination thereof, but they are not limited thereto. The semiconductor layer 154 may include a channel region and doped regions disposed on both sides of the channel region and electrically connected to the source electrode 173 and the drain electrode 175, respectively.

The gate insulating layer 140 may include an organic material, an inorganic material, or an organic-inorganic material, and may include, for example, an oxide, a nitride, or an oxynitride, and may include, for example, silicon oxide, silicon nitride, silicon oxynitride, or a combination thereof, but is not limited thereto. In the drawing, an example in which the gate insulating layer 140 is formed on the entire surface of the lower substrate 110 is illustrated, but the present disclosure is not limited thereto and may be selectively formed between the gate electrode 124 and the semiconductor layer 154. The gate insulating layer 140 may be formed of one or two or more layers.

The source electrode 173 and the drain electrode 175 may include, for example, a low-resistance metal such as aluminum (Al), molybdenum (Mo), copper (Cu), titanium (Ti), silver (Ag), gold (Au), an alloy thereof, or a combination thereof, but are not limited thereto. The source electrode 173 and the drain electrode 175 may be electrically connected to the doped regions of the semiconductor layer 154, respectively. The source electrode 173 is electrically connected to a data line (not shown), and the drain electrode 175 is electrically connected to a light emitting element 180.

An interlayer insulating layer 145 is additionally formed between the gate electrode 124 and the source/drain electrodes 173 and 175. The interlayer insulating layer 145 may include an organic material, an inorganic material, or an organic-inorganic material, for example, oxide, nitride, or oxynitride, for example, silicon oxide, silicon nitride, silicon oxynitride, or a combination thereof, but is not limited thereto. The interlayer insulating layer 145 may be formed of one or two or more layers.

A protective layer 160 is formed on the thin film transistor TFT. The protective layer 160 may be, for example, a passivation layer. The protective layer 160 may include an organic material, an inorganic material, or an organic-inorganic material, for example, polyacrylic, polyimide, polyamide, polyamideimide), or a combination thereof, but is not limited thereto. The protective layer 160 may be formed of one or two or three or more layers.

In an embodiment, one of the first electrode 1, 10 and the second electrode 5, 50, may be a pixel electrode linked to the TFT and the other of them may be a common electrode.

In an embodiment, the light emitting device or the display device including the same may be used in a top emission type, a bottom emission type, a dual emission type, or a combination thereof.

In an embodiment, the first electrode 1, 10 may be a light transmitting electrode and the second electrode 5, 50 may be a reflective electrode, and the display panel may be a bottom emission type display panel that emits light toward the first electrode 10 and the lower substrate 110, if present. In an embodiment, the first electrode 1, 10 may be a reflective electrode and the second electrode 5, 50 may be a light transmitting electrode, and the display panel may be a top emission type display panel that emits light to the opposite side of the first electrode 10 and the lower substrate 110 if present. In an embodiment, both the first electrode and the second electrode may be translucent electrodes, and the display panel 1000 may be a both side emission type display panel that emits light on the substrate side and on the opposite side of the substrate.

The display device or an electronic apparatus may include (or may be) a television, a virtual reality/augmented reality (VR/AR), a handheld terminal, a monitor, a notebook computer, an electronic display board, a camera, or a part for an automatic, e.g., autonomous, vehicle.

Specific examples are described below. However, the examples described below are only for specifically illustrating or explaining the disclosure, and the scope of the disclosure is not limited thereto.

### Examples

### 1. Electroluminescence Measurement

A current according to an applied voltage is measured with a Keithley 2635B source meter, and a CS2000 spectrometer is used to measure electroluminescent properties (e.g., luminance) of a light-emitting device.

### 2. Life-span Characteristics

T90 and T50 are measured with an initial luminance of 650 nit.

### 3. Electron microscopic analysis

A transmission electron microscopy analysis was performed using the UTF30 Tecnai electron microscope.

The following synthesis is performed under an inert gas atmosphere (e.g., under nitrogen) unless otherwise specified. A precursor content is provided as a molar content, unless otherwise specified.

### Synthesis Example 1:

2 moles per liter (M) of a Se/trioctylphosphine (TOP) stock solution, 1M of a S/TOP stock solution, and 0.1M of a Te/TOP stock solution were prepared by dispersing selenium (Se), sulfur (S), and tellurium (Te) in trioctylphosphine (TOP), respectively. In a reactor containing trioctylamine, 0.125 millimoles (mmol) of zinc acetate was added to the reactor with oleic acid and heated at 120 °C under vacuum. After 1 hour, nitrogen was introduced into the reactor.

The reactor was heated to 300 °C, and the Se/TOP stock solution and the Te/TOP stock solution in a Te:Se mole ratio of 1:20 were rapidly added to, e.g., injected into, the reactor. After 40 minutes, the reaction was complete, and the reaction solution was rapidly cooled to room temperature and acetone was added to the reactor. The resulting product mixture was centrifuged and the precipitate was separated and dispersed in toluene to prepare a ZnSeTe core particle dispersion.

Amounts of 1.8 mmol of zinc acetate and oleic acid were added to a flask containing trioctylamine and the prepared mixture was heated at 120 °C under vacuum for 10 minutes. Nitrogen (N₂) was then introduced into the reactor, the reactor was heated to 180 °C, and the prepared ZnTeSe core particle dispersion was added quickly to the reactor. The Se/TOP stock solution and the S/TOP stock solution were also added to the reactor, and the reactor temperature was raised to about 280 °C. After 2 hours, the reaction was complete, and the reactor was cooled to room temperature and ethanol was added to facilitate precipitation of the semiconductor nanoparticles, which were separated by centrifuge. The prepared semiconductor nanoparticles emitted blue light, and a photoluminescent spectroscopy analysis using Hitachi F-7000 spectrophotometer confirmed that the blue light had a maximum emission peak wavelength of about 455 nanometers (nm).

The synthesized semiconductor nanoparticles (optical density 0.25 at 420 nm, 6 milliliters (mL)) were precipitated with ethanol and centrifuged and the separated nanoparticles dispersed in cyclohexylbenzene to prepare a QD dispersion.

### Synthesis Example 2: Synthesis of ZnMgO nanoparticles

Zinc acetate dihydrate and magnesium acetate tetrahydrate were added into a reactor including dimethylsulfoxide at a pre-determined mole ratio according to the following chemical formula and heated at 60 °C in an air atmosphere. Subsequently, a solution of tetramethylammonium hydroxide pentahydrate and ethanol was added into the reactor in a dropwise fashion at a speed of 3 milliliters per minute (mL/min). After stirring the mixture, the prepared Zn₁₋ₓMgₓO nanoparticles were centrifuged, separated, and dispersed in ethanol to provide an ethanol dispersion of Zn₁₋ₓMgₓO (x = 0.15) nanoparticles.

The prepared nanoparticles were analyzed by a transmission electron microscopic analysis, and the results show that the particles have an average particle size of about 3 nm.

### Example 1

The dispersion of zinc magnesium oxide nanoparticles prepared in Synthesis Example 2 was used as an electron transport layer dispersion (hereinafter, ETL dispersion). A polyacrylic acid (weight average molecular weight: 450,000 product name: poly(acrylic acid), PAA, Sigma-Aldrich (181285)) was dissolved in ethanol, and added with citric acid (HOC(COOH)(CH₂COOH)₂, CAS number 77-92-9) at a concentration of 0.1M to produce an acid material containing composition (a concentration of the polymeric acid compound: 5% by weight).

A glass substrate deposited with indium tin oxide (ITO) was surface treated with ultraviolet (UV)-ozone for 15 minutes, and then spin-coated with a poly(3,4-ethylenedioxythiophene) polystyrene sulfonate (PEDOT:PSS) solution (H.C. Starks) and heated at 150 °C for 10 minutes under air atmosphere and heated again at 150 °C for 20 to 30 minutes under N₂ atmosphere to provide a hole injection layer (HIL) having a thickness of 120 nm.

Subsequently, poly[(9,9-dioctylfluorenyl-2,7-diyl-co(4,4'-(N-4-butylphenyl)diphenylamine] solution (TFB) (Sumitomo) was spin-coated on the hole injection layer and heated at 150 °C for 30 minutes to provide a hole transport layer (HTL) having a thickness of 40 nm.

The QD dispersion prepared from Synthesis Example 1 was used to prepare a light emitting layer having a thickness of 25 nm on the prepared hole transport layer to, which is then heat-treated at a temperature of about 140 °C under an argon atmosphere for 30 minutes. After the heat treatment, an electron transport layer was formed on the light emitting layer using the ETL dispersion and heat treatment was performed at 140°C to form an electron transport layer (thickness: 40 nm).

Magnesium and silver were thermally deposited on the prepared electron transport layer to prepare a second electrode or a thin film conductor of a thickness of about 20 nm, providing a stacked structure (hereinafter, referred to as "QD stack").

The manufactured stacked structure was subjected to a post treatment as follows to obtain a light emitting element:
As shown in FIG. 6 or FIG. 7, the acid material containing composition thus prepared was placed in a form of a droplet and then was spin-coated on a surface of an open box-shaped container (e.g., an encapsulation glass), and then the solvent was removed therefrom to form an acid material film having a thickness of about 3 µm.

In the sealed space defined by the container (i.e., encap glass), the stacked structure was placed so that the acid material film was spaced apart from and faced to the thin film conductor, as shown in FIG. 6 or FIG. 7, and then kept in a 70°C constant temperature oven for 5 days to obtain a light emitting device.

Electroluminescent properties of the prepared light emitting device are measured and the results are shown in Table 1.

### Example 2

A light emitting device was prepared in the same manner as Example 1 except for using malic acid (Cas. No. 6915-15-7, from Sigma Aldrich) instead of the citric acid.

Electroluminescent properties of the prepared light emitting device are measured and the results are shown in Table 1. The luminous efficiency of the prepared light emitting device was about 13 cd/A.

### Comparative Example 1

A light emitting device was prepared in the same manner as Example 1 except that the acid material containing composition included an acrylate resin (LOCTITE AA 366, from Henkel Co. Ltd.) and acrylic acid (from Sigma Aldrich) instead of the PAA and the citric acid.

Electroluminescent properties of the prepared light emitting device are measured and the results are shown in Table 1. The luminous efficiency of the prepared light emitting device was about 8 cd/A.

**Table 1**

| | Acid material | Max. EQE | Max. Lum | Relative T90 | Relative T50 |
|---|---|---|---|---|---|
| Example 1 | PAA + CtA | 9.6% | 43120 nit | 8.8 | 2.6 |
| Example 2 | PAA + MA | 11.1% | 97713 nit | 19.7 | 6.1 |
| Com. Example 1 | Resin + AA | 7.6% | 40007 nit | 1 | 1 |

| | | | | | |
|---|---|---|---|---|---|
| Max. EQE: Maximum External Quantum Efficiency Max. Lum: Maximum Luminance nit: cd/m² PAA: polyacrylic acid CtA: citric acid MA: malic acid Resin: Acrylate resin Relative T50: T50 (hour) of the device / T50 (hour) of Comparative | | | | | |

### Example 1

Relative T90: T90 (hour) of the device / T90 (hour) of Comparative

### Example 1

From the results of Table 1, it is confirmed that the electroluminescent devices of the embodiments exhibit improved electroluminescence properties and extended lifespan compared to the devices of the comparative examples.

### Reference Example 1:

Electroluminescence properties were measured for the stacked structure that was not subjected to the post-treatment process. The maximum EQE of the manufactured light emitting device was 6.2%, and the maximum luminance was 30518 nit. The relative T90 and the relative T50 of the stacked structure were 0.27 and 0.19, respectively.

### Example 3

A light emitting device was obtained in the same manner as in Example 1, except that post-processing was performed as follows.

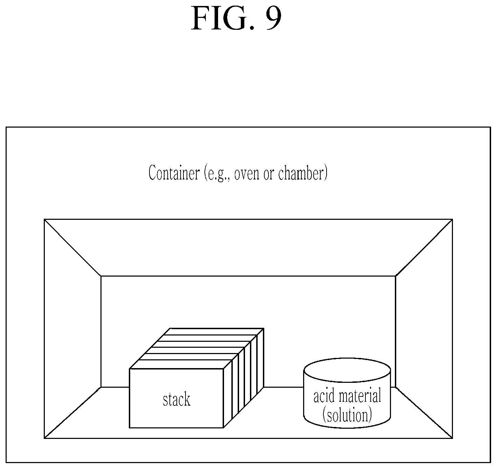

Polyacrylic acid (weight average molecular weight: 450,000 product name: Poly(acrylic acid), PAA, manufacturer, and Product Number: Sigma-Aldrich (181285)) was dissolved in ethanol (solid concentration: 5 wt%) and a powder of citric acid (HOC(COOH)(CH₂COOH)₂, Cas number 77-92-9) was added thereto and dissolved (at a concentration 0.1M of the citric acid)to prepare an acid material-containing composition. The acid material-containing composition (PAA 5 wt% + CtA 0.1M) was placed in a heat-resistant glass container, and as shown in FIG. 9, the acid material-containing composition and the stacked structure prepared were placed in a high-temperature sealed oven (manufactured by LK lab Korea, model name: LO-VP232N), and then the temperature of the sealed oven is maintained at 90°C for 2 hours.

The manufactured light emitting device measures electroluminescence properties and summarizes the results in Table 2.

### Example 4

Citric acid (HOC(COOH)(CH₂COOH)₂, Cas number 77-92-9) is dissolved in water to prepare an aqueous citric acid solution having a concentration of 0.1 M. A light emitting element is prepared according to the same method as in Example 3, except that only 10 mL of the prepared aqueous citric acid solution without PAA is placed in a heat-resistant glass beaker as an acid material-containing composition.

The manufactured light emitting device measures electroluminescence properties and summarizes the results in Table 2.

### Example 5

Citric acid (HOC(COOH)(CH₂COOH)₂ and Cas number 77-92-9) are dissolved in water to prepare an aqueous citric acid solution having a concentration of 1 M. A light emitting element is prepared according to the same method as in Example 3, except that only 10 mL of the prepared aqueous citric acid solution without PAA is placed in a heat-resistant glass beaker as an acid material-containing composition.

The manufactured light emitting device measures electroluminescence properties and summarizes the results in Table 2.

### Reference Example 2

Without an acid material-containing composition, a stacked structure is disposed in a high-temperature sealed oven as shown in Fig. 9 and then the temperature of the sealed oven is maintained at 90 degrees for 2 hours.

The manufactured light emitting device measures electroluminescence properties and summarizes the results in Table 2.

**Table 2**

| | Acid material | Max. EQE | Max. Lum | Relative T90 |
|---|---|---|---|---|
| Example 3 | PAA 5 wt% + CtA 0.1 M | about 6% | 45591 nit | 13.4 |
| Example 4 | CtA 0.1 M (in H₂O) | 9.2% | 44400 nit | 19 |
| Example 5 | CtA 1 M (in H₂O) | 8.9% | 46149 nit | 13.5 |
| Ref. Example 2 | None | 0.78% | 2551 nit | 0.17 |

| | | | | |
|---|---|---|---|---|
| Max. EQE: Maximum External Quantum Efficiency Max. Lum: Maximum Luminance nit: cd/m² PAA: polyacrylic acid CtA: citric acid | | | | |

From the results of Table 2, it may be confirmed that the light emitting devices of Examples may exhibit improved electroluminescence properties and life characteristics as compared with Reference Example.

While this disclosure has been described in connection with what is presently considered to be practical embodiments, it is to be understood that the invention is not limited to the disclosed embodiments. On the contrary, it is intended to cover various modifications and equivalent arrangements included within the scope of the appended claims.

## Claims

1. A method of producing a light emitting device, which comprises:
forming a light emitting layer comprising a semiconductor nanoparticle on a first electrode;
forming an electron transport layer including a metal oxide nanoparticle on the light emitting layer;
forming a thin film conductor on the electron transport layer to obtain a stacked structure; and
conducting a post-treatment for the stacked structure with an acid material and a container,
wherein the light emitting layer is configured to emit a first light when a voltage is applied,
wherein a thickness of the thin film conductor is greater than or equal to 1 nanometer (nm) and less than 100 nm,
wherein the post-treatment comprises
placing at least a portion of the stacked structure and the acid material together in a space defined by the container; and
keeping the defined space at a post-treatment temperature of greater than or equal to 40 degrees in Celsius (°C) and less than or equal to 200°C;
wherein the at least a portion of the stacked structure comprises the electron transport layer and the thin film conductor; and
wherein the acid material comprises a polymeric acid compound, a non-polymeric carboxylic acid compound, or a combination thereof.

2. The method of claim 1, wherein the acid material exhibits a solubility of greater than or equal to 1 gram per liter, with respect to water.

3. The method of claims 1 or 2, wherein the metal oxide nanoparticles has a size of greater than or equal to 1 nm and less than or equal to 30 nm, and the metal oxide nanoparticle comprises zinc; and optionally a Group IIA metal, Zr, W, Li, Ti, Y, gallium, indium, tin (Sn), cobalt (Co), vanadium (V), or a combination thereof.

4. The method of any of claims 1-3, wherein the thin film conductor has a thickness of greater than 10 nm and less than or equal to 50 nm,
or, wherein the thin film conductor comprises silver, aluminum, magnesium, tungsten, nickel, cobalt, platinum, palladium, calcium, LiF, copper, gold, or a combination thereof.

5. The method of any of claims 1-4, wherein the thin film conductor is configured to have a light transmittance of greater than or equal to 25% and less than or equal to 100% for the first light, and
wherein the first electrode is configured to reflect at least a portion of the first light.

6. The method of any of claims 1-5, wherein the acid material is spaced apart from the electron transport layer and the thin film conductor, and
wherein the acid material is placed to face the thin film conductor.

7. The method of any of claims 1-6, wherein the polymeric acid compound comprises a carboxyl group (COOH) group, a phosphonic acid (PO(OH)₂) group, a sulfonic acid (SOsH) group, or a combination thereof in a repeating unit, and
wherein the non-polymeric carboxylic acid compound comprises a carboxylic acid compound represented by R(COOH)ₙ, where R is a C1 to C50 substituted or unsubstituted aliphatic or aromatic hydrocarbon group, and n is an integer of 2 to 10.

8. The method of any of claims 1-7, wherein the non-polymeric carboxylic acid compound has a molecular weight of greater than or equal to 100 grams per mole (g/mol) and less than or equal to 500 g/mol, or
wherein the polymeric acid compound comprises an average molecular weight of greater than or equal to 20,000 g/mol and less than or equal to 550,000 g/mol.

9. The method of any of claims 1-8, wherein the container is an oven including a hollow chamber and an element configured to heat the chamber in a controlled way, and the acid material is provided in a solution form.

10. The method of any of claims 1-9, wherein the polymeric acid compound comprises a poly(meth)acrylic acid, a copolymer thereof, or a combination thereof; and/or
wherein the non-polymeric carboxylic acid compound includes benzoic acid, succinic acid, maleic acid, fumaric acid, malic acid, glutaric acid, adipic acid, pimelic acid, citric acid, oxalic acid, malonic acid, phthalic acid, isophthalic acid, terephthalic acid, trimellitic acid, hemimellitic acid, azelaic acid, suberic acid, tartaric acid, itaconic acid, dodecanedioic acid, acetic acid, or a combination thereof.

11. A light emitting device, which comprises:
a first electrode and a second electrode,
a light emitting layer disposed between the first electrode and the second electrode, and
an electron transport layer disposed between the light emitting layer and the second electrode;
wherein the light emitting layer comprises a semiconductor nanoparticle, and the light emitting layer is configured to emit a first light,
wherein the electron transport layer comprises a metal oxide nanoparticle, the metal oxide nanoparticle has a size of greater than or equal to 1 nm and less than or equal to 30 nm, and
the metal oxide nanoparticle comprises zinc; and optionally a Group IIA metal, zirconium, tungsten, lithium, titanium, yttrium, aluminum, gallium, indium, tin, cobalt, vanadium, or a combination thereof,
wherein the second electrode has a thickness of greater than or equal to 11 nm and less than or equal to 50 nm, and the second electrode exhibits a light transmittance for the first light, which is greater than or equal to 50%, and
wherein the first electrode is configured to reflect at least a portion of the first light.

12. The light emitting device of claim 11, wherein the second electrode has a thickness of greater than or equal to 12 nm and less than or equal to 40 nm.

13. The light emitting device of claims 11 or 12, wherein the light emitting device further comprises a film of an acid material, and wherein the film of the acid material is spaced apart from the electron transport layer and the second electrode and disposed to face the electron transport layer and the second electrode;
preferably wherein the film of the acid material comprises a polymeric acid compound comprising a carboxyl group (COOH), a phosphonic acid (PO(OH)₂) group, a sulfonic acid (SOsH) group, or a combination thereof in a repeating unit; a non-polymeric carboxylic acid compound; or a combination thereof;
preferably wherein the polymeric acid compound comprises a poly(meth)acrylic acid, a copolymer thereof, or a combination thereof, and wherein the non-polymeric carboxylic acid compound comprises a carboxylic acid compound represented by R(COOH)ₙ (where R is a substituted or unsubstituted aliphatic or aromatic hydrocarbon group of C1 to C50, and n is an integer of 2 to 10), or a combination thereof.

14. The light emitting device of any of claims 11-13, wherein the light emitting layer is configured to emit blue light, and
wherein the light emitting device exhibits a maximum quantum efficiency of greater than or equal to 4%; a maximum luminance of greater than or equal to 4 candelas per square meter (cd/m²); a luminous efficiency of greater than or equal to about 12 candelas per ampere (cd/A); or a combination thereof.

15. A display device comprising the light emitting device of any of claims 11-14;
preferably wherein the display device comprises an augmented reality device, a virtual reality device, a handheld terminal, a monitor, a notebook computer, a television, an electronic display board, a camera, or an electronic component for an automatic vehicle.
